# EUROPEAN PATENT APPLICATION

(11) **EP 2 330 633 A1**
(43) Date of publication of application: **08.06.2011**
(21) Application number: 09809603.5
(22) Date of filing: 28.08.2009
(51) Int. Cl.: H01L 31/04

(54) **PHOTOELECTRIC CONVERSION DEVICE MANUFACTURING METHOD, PHOTOELECTRIC CONVERSION DEVICE, AND PHOTOELECTRIC CONVERSION DEVICE MANUFACTURING SYSTEM**

(30) Priority: 29.08.2008 JP 2008222818; 22.04.2009 WO PCT/JP2009/057976
(71) Applicant: Ulvac, Inc., Chigasaki-shi Kanagawa 253-8543 (JP)
(72) Inventor: ASAHINA, Shinichi, Sammu-shi Chiba 289-1226 (JP); UCHIDA, Hiroto, Chigasaki-shi Kanagawa 253-8543 (JP); ASARI, Shin, Sammu-shi Chiba 289-1226 (JP); HASHIMOTO, Masanori, Sammu-shi Chiba 289-1226 (JP); FUJINAGA, Tetsushi, Sammu-shi Chiba 289-1226 (JP); KOBAYASHI, Tadamasa, Sammu-shi Chiba 289-1226 (JP); WAKAI, Masafumi, Sammu-shi Chiba 289-1226 (JP); IMAKITA, Kenichi, Sammu-shi Chiba 289-1226 (JP); UE, Yoshinobu, Sammu-shi Chiba 289-1226 (JP); SAITO, Kazuya, Sammu-shi Chiba 289-1226 (JP); NAKAMURA, Kyuzo, Chigasaki-shi Kanagawa 253-8543 (JP)
(74) Representative: Eisenführ, Speiser & Partner
(86) International application number: PCT/JP2009/004232
(87) International publication number: WO 2010/023948

(57) **Abstract**

A photoelectric conversion device manufacturing method, includes: continuously forming a first p-type semiconductor layer (31), a first i-type semiconductor layer (32), and a first n-type semiconductor layer (33), which constitute a first-photoelectric conversion unit (3), and a second p-type semiconductor layer (41) which constitutes a second-photoelectric conversion unit (4), in decompression chambers that are different from each other; exposing the second p-type semiconductor layer (41) to an air atmosphere; and forming a second i-type semiconductor layer (42) and a second n-type semiconductor layer (43), which constitute the second-photoelectric conversion unit, on the second p-type semiconductor layer (41) of the second-photoelectric conversion unit (4) which was exposed to the air atmosphere, in the same decompression chamber.

## Description

### BACKGROUND OF THE INVENTION

### Field of the Invention

The present invention relates to a photoelectric conversion device manufacturing method, a photoelectric conversion device, and a photoelectric conversion device manufacturing system, particularly, technique of improving the performance of a tandem-type photoelectric conversion device which is configured so that two photoelectric conversion units are formed and stacked in layers therein.

This application claims priority from Japanese Patent Application No. 2008-222818 filed on August 29, 2008, and International Patent Application No. PCT/JP2009/057976 filed on April 22, 2009, the contents of which are incorporated herein by reference in their entirety.

### Background Art

In recent years, photoelectric conversion devices have been widely used for solar cells, photodetectors, or the like, in particular, in view of efficient use of energy, solar cells are more widely used than ever before.

Specifically, a photoelectric conversion device in which single crystal silicon is utilized has a high level of energy conversion efficiency per unit area.

However, in contrast, in the photoelectric conversion device in which the silicon single crystal is utilized, single crystal silicon ingot is sliced, a sliced silicon wafer is used in the solar cell; therefore, a large amount of energy is spent for manufacturing the ingot, and the manufacturing cost is high.

For example, at the moment, in a case of realizing a photoelectric conversion device having a large area which is placed outdoors or the like, when being manufactured by use of single crystal silicon, the cost considerably increases.

Consequently, as a low-cost photoelectric conversion device, a photoelectric conversion device that can be further inexpensively manufactured and that employs a thin film made of amorphous silicon (hereinafter, refer to a-Si thin film) is in widespread use.

However, conversion efficiency of a photoelectric conversion device in which an amorphous-silicon thin film is utilized is lower than the conversion efficiency of a crystalline photoelectric conversion device in which single-crystalline silicon, polysilicon, or the like is utilized.

For this reason, as a structure for improving the conversion efficiency of the photoelectric conversion device, a tandem-type structure in which two photoelectric conversion units are stacked in layers has been proposed.

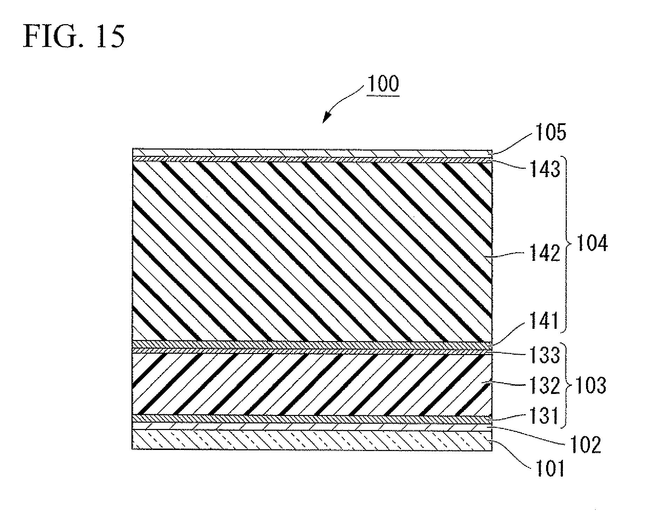

For example, as shown in FIG. 15, a tandem-type photoelectric conversion device 100 is known.

In the photoelectric conversion device 100, a transparent substrate 101 having an insulation property, on which a transparent-electroconductive film 102 is disposed, is employed.

A pin-type first-photoelectric conversion unit 103 that is obtained by stacking a p-type semiconductor layer 131, an i-type silicon layer (amorphous silicon layer) 132, and an n-type semiconductor layer 133 in this order is formed on the transparent-electroconductive film 102.

A pin-type second-photoelectric conversion unit 104 that is obtained by stacking a p-type semiconductor layer 141, an i-type silicon layer (crystalline-silicon layer including microcrystal, hereinafter, crystalline-silicon layer) 142, and an n-type semiconductor layer 143 in this order is formed on the first-photoelectric conversion unit 103.

Additionally, a back-face electrode 105 is formed on the second-photoelectric conversion unit 104.

As a method for manufacturing the foregoing tandem-type photoelectric conversion device, a manufacturing method disclosed in Japanese Patent No. 3589581 is known.

In the manufacturing method, plasma-CVD reaction chambers, in which a p-type semiconductor layer, an i-type-amorphous-silicon based photoelectric conversion layer, and an n-type semiconductor layer which constitute an amorphous-type photoelectric conversion unit (first-photoelectric conversion unit) are formed, are different from each other.

Additionally, in the manufacturing method, a p-type semiconductor layer, an i-type-crystalline silicon based photoelectric conversion layer, and an n-type semiconductor layer which constitute a crystalline-type photoelectric conversion unit (second-photoelectric conversion unit) are formed in the same plasma-CVD reaction chamber.

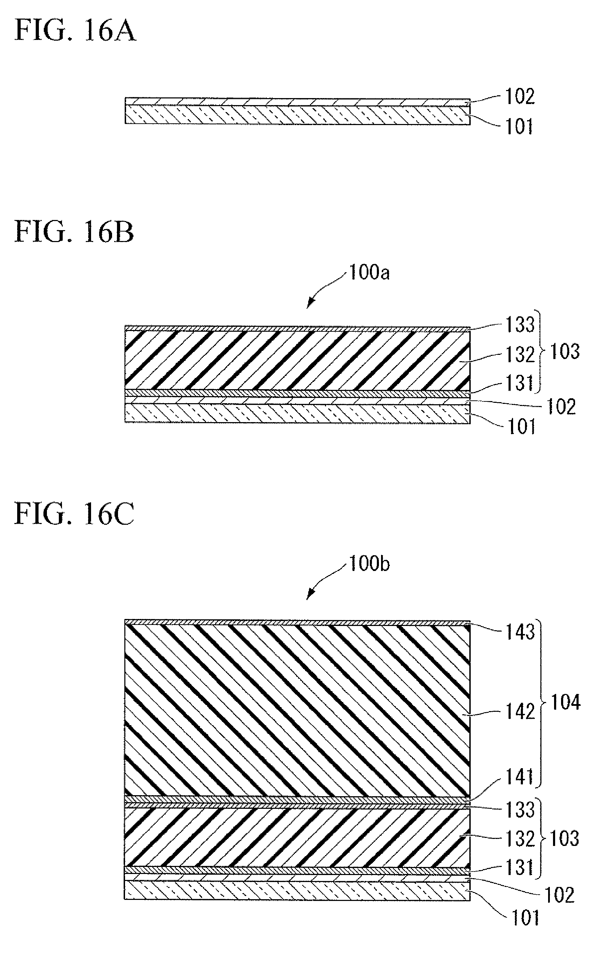

In the tandem-type photoelectric conversion device 100, as shown in FIG. 16A, firstly, an insulative-transparent substrate 101 on which a transparent-electroconductive film 102 is formed is prepared.

Next, as shown in FIG. 16B, plasma-CVD reaction chambers, in which a p-type semiconductor layer 131, an i-type silicon layer (amorphous silicon layer) 132, and an n-type semiconductor layer 133 are formed on the transparent-electroconductive film 102 formed on the insulative-transparent substrate 101, are different from each other.

Consequently, a pin-type first-photoelectric conversion unit 103 in which layers are sequentially stacked is formed on the insulative-transparent substrate 101.

Continuously, the n-type semiconductor layer 133 of the first-photoelectric conversion unit 103 is exposed to an air atmosphere and is transferred to a plasma-CVD reaction chamber, thereafter, as shown in FIG. 16C, a p-type semiconductor layer 141, an i-type silicon layer (crystalline-silicon layer) 142, and an n-type semiconductor layer 143 are formed in the same plasma-CVD reaction chamber, on the n-type semiconductor layer 133 of the first-photoelectric conversion unit 103 which was exposed to an air atmosphere.

For this reason, a pin-type second-photoelectric conversion unit 104 in which layers are sequentially stacked is formed.

Consequently, due to forming a back-face electrode 105 on the n-type semiconductor layer 143 of the second-photoelectric conversion unit 104, a photoelectric conversion device 100 is obtained as shown in FIG. 15.

The tandem-type photoelectric conversion device 100 composed of the above-described structure can be manufactured by two broadly-divided manufacturing systems.

Firstly, in a first manufacturing system, a first-photoelectric conversion unit 103 is formed by use of a so-called in-line type first-film-formation apparatus in which a plurality of film-formation reaction chambers referred to as chamber are disposed so as to be linearly connected (linear arrangement).

Each of layers constituting the first-photoelectric conversion unit 103 is formed in the film-formation reaction chambers that are different from each other in the first-film-formation apparatus.

After the first-photoelectric conversion unit 103 is formed, a second-photoelectric conversion unit 104 is formed by use of a so-called batch type second-film-formation apparatus.

Each of layers constituting the second-photoelectric conversion unit 104 is formed in a single film-formation reaction chamber in the second-film-formation apparatus.

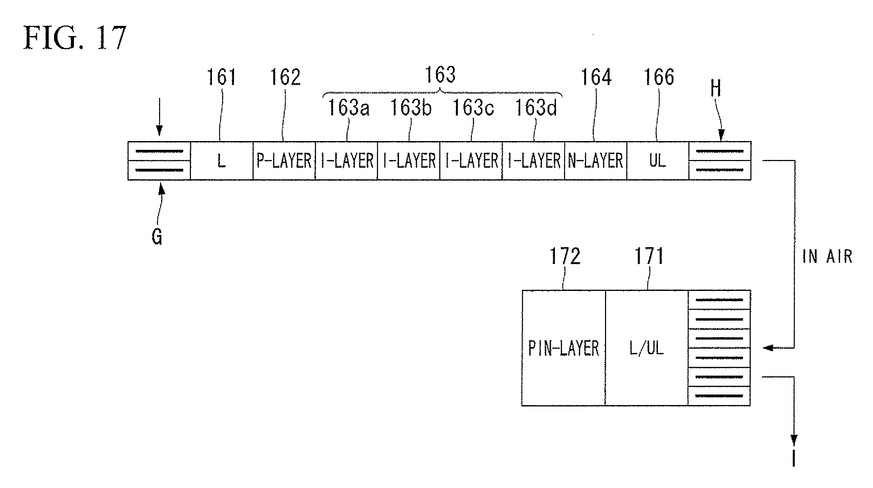

Specifically, for example, as shown in FIG. 17, the first manufacturing system includes: a first-film-formation apparatus in which a load chamber (L: Lord) 161, a p-layer film-formation reaction chamber 162, i-layer film-formation reaction chambers 163, an n-layer film-formation reaction chamber 164, and an unload chamber (UL: Unlord) 166 continuously and linearly arranged; and a second-film-formation apparatus in which a load-unload chamber (L/UL) 171 and a pin-layer film-formation reaction chamber 172 are arranged.

In the first manufacturing system, firstly, a substrate is transferred to the load chamber (L: Lord) 161 and is disposed therein, the internal pressure thereof is reduced.

Continuously, while the reduced-pressure atmosphere being maintained, the p-type semiconductor layer 131 of the first-photoelectric conversion unit 103 is formed in the p-layer film-formation reaction chamber 162, the i-type silicon layer (amorphous silicon layer) 132 is formed in the i-layer film-formation reaction chambers 163, and the n-type semiconductor layer 133 is formed in the n-layer film-formation reaction chamber 164.

The substrate on which the first-photoelectric conversion unit 103 was formed is transferred to the unload chamber (UL: Unlord) 166.

The unload chamber (UL: Unlord) 166 returns from the reduced-pressure atmosphere to an air atmosphere, the substrate is transferred from the unload chamber (UL: Unlord) 166.

The substrate that was processed in the above-described manner in the first-film-formation apparatus, is exposed to an air atmosphere, and is transferred to the second-film-formation apparatus.

The substrate on which the first-photoelectric conversion unit 103 was formed is transferred to and disposed in the load-unload chamber (L/UL) 171, and internal pressure of the load-unload chamber (L/UL) 171 is reduced.

The load-unload chamber (L/UL) 171 reduces the internal pressure thereof after the substrate is transferred thereto, and returns from the reduced-pressure atmosphere to an air atmosphere when the substrate is transferred from the load-unload chamber 171.

The substrate is transferred to the pin-layer film-formation reaction chamber 172 via the load-unload chamber (L/UL) 171.

The p-type semiconductor layer 141, the i-type silicon layer (crystalline-silicon layer) 142, and the n-type semiconductor layer 143 of the second-photoelectric conversion unit 104 is sequentially formed on the n-type semiconductor layer 133 of the first-photoelectric conversion unit 103 in the same reaction chamber, that is, in the pin-layer film-formation reaction chamber 172.

At the G point of the first manufacturing system shown in FIG. 17, the insulative-transparent substrate 101 on which the transparent-electroconductive film 102 is formed is prepared as shown in FIG. 16A.

Additionally, at the H point shown in FIG. 17, a first intermediate part 100a of the photoelectric conversion device in which the first-photoelectric conversion unit 103 is provided is formed on the transparent-electroconductive film 102 formed on the insulative-transparent substrate 101 as shown in FIG. 16B.

Consequently, at the I point shown in FIG. 17, a second intermediate part 100b of the photoelectric conversion device in which the second-photoelectric conversion unit 104 is provided is formed on the first-photoelectric conversion unit 103 as shown in FIG. 16C.

In FIG. 17, the in-line type first-film-formation apparatus is configured to process two substrates at the same time.

The i-layer film-formation reaction chambers 163 are constituted of four reaction chambers 163a to 163d.

Additionally, in FIG. 17, the batch type second-film-formation apparatus is configured to process six substrates at the same time.

On the other hand, in the second manufacturing system, the first-photoelectric conversion unit 103 is formed by use of the first-film-formation apparatus which is similar to that shown in FIG. 17.

After the first-photoelectric conversion unit 103 is formed, the second-photoelectric conversion unit 104 is formed by use of a so-called single wafer type second-film-formation apparatus in which the second-photoelectric conversion unit 104 is formed using a plurality of film-formation reaction chambers for exclusive use for forming each layer of the second-photoelectric conversion unit 104.

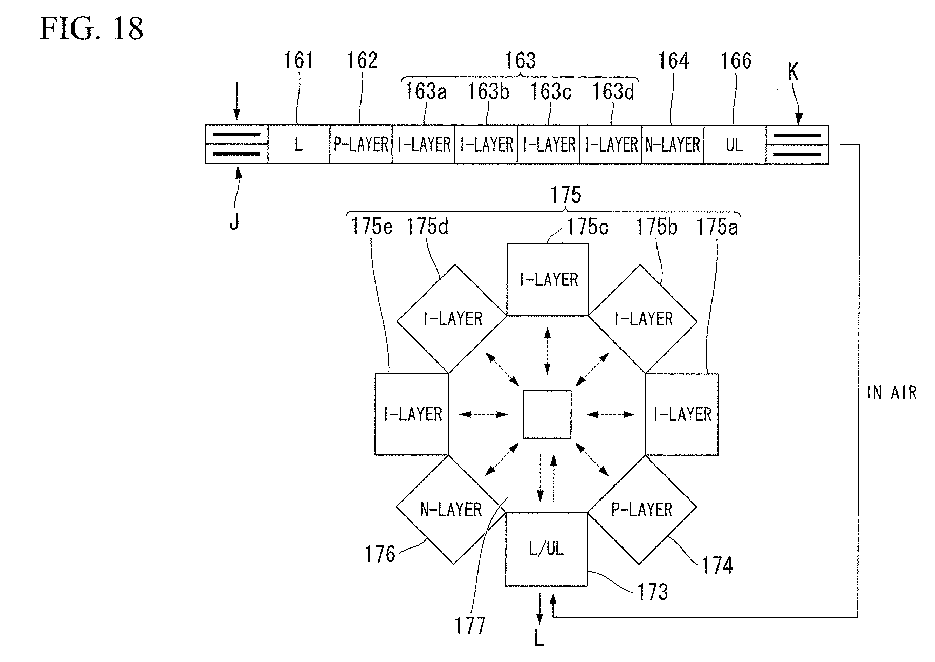

Specifically, for example, as shown in FIG. 18, the second manufacturing system includes: the first-film-formation apparatus having a structure similar to FIG. 17; and a second-film-formation apparatus in which a load-unload chamber (L/UL) 173, a p-layer film-formation reaction chamber 174, i-layer film-formation reaction chambers 175, an n-layer film-formation reaction chamber 176, and an intermediate chamber 177 are arranged.

In the second manufacturing system, the first-photoelectric conversion unit 103 is formed on the substrate in the first-film-formation apparatus similar to the first manufacturing system as described above, and the substrate is transferred from the unload chamber (UL: Unlord) 166.

The substrate that was processed in the above-described manner in the first-film-formation apparatus, is exposed to an air atmosphere, and is transferred to the second-film-formation apparatus.

The substrate on which the first-photoelectric conversion unit 103 was formed is transferred to and disposed in the load-unload chamber (L/UL) 173, and internal pressure of the load-unload chamber (L/UL) 171 is reduced.

The load-unload chamber (L/UL) 173 reduces the internal pressure thereof after the substrate is transferred thereto, and returns from the reduced-pressure atmosphere to an air atmosphere when the substrate is transferred from the load-unload chamber 173.

The substrate is transferred to the intermediate chamber 177 via the load-unload chamber (L/UL) 173.

In addition, the substrate is transferred between the intermediate chamber 177 and the p-layer film-formation reaction chamber 174, between the intermediate chamber 177 and the i-layer film-formation reaction chambers 175, and between the intermediate chamber 177 and the n-layer film-formation reaction chamber 176.

The p-type semiconductor layer 141 of the second-photoelectric conversion unit 104 is formed on the n-type semiconductor layer 133 of the first-photoelectric conversion unit 103 in the p-layer film-formation reaction chamber 174.

The i-type silicon layer (crystalline-silicon layer) 142 is formed in the i-layer film-formation reaction chambers 175.

The n-type semiconductor layer 143 is formed in the n-layer film-formation reaction chamber 176.

As described above, one layer of the p-type semiconductor layer 141, the i-type silicon layer 142, and the n-type semiconductor layer 143 is formed on one substrate in each of the reaction chambers 174, 175, and 176.

Also, in order to stack the p-type semiconductor layer 141, the i-type silicon layer 142, and the n-type semiconductor layer 143 in layers, a transfer device (not shown in the figure), which is provided at the intermediate chamber 177, transfers the substrate to each of the reaction chambers 174, 175, and 176 and transfers the substrate from each of the reaction chambers 174, 175, and 176.

At the J point of the second manufacturing system shown in FIG. 18, the insulative-transparent substrate 101 on which the transparent-electroconductive film 102 is formed is prepared as shown in FIG. 16A.

Additionally, at the K point shown in FIG. 18, a first intermediate part 100a of the photoelectric conversion device in which the first-photoelectric conversion unit 103 is provided is formed on the transparent-electroconductive film 102 formed on the insulative-transparent substrate 101 as shown in FIG. 16B.

Consequently, at the L point shown in FIG. 18, a second intermediate part 100b of the photoelectric conversion device in which the second-photoelectric conversion unit 104 is provided is formed on the first-photoelectric conversion unit 103 as shown in FIG. 16C.

In FIG. 18, the in-line type first-film-formation apparatus is configured to process two substrates at the same time in each reaction chamber.

The i-layer film-formation reaction chambers 163 are constituted of four reaction chambers 163a to 163d.

Additionally, in FIG. 18, the i-layer film-formation reaction chambers 175 of the single wafer type second-film-formation apparatus are constituted of five reaction chambers 175a to 175e.

Because of this, the second-film-formation apparatus simultaneously forms the i-layers in which the time to form a film is long, and thereby makes the takt time short.

In addition, as an example, FIG. 18 illustrates the individual chambers 173 to 176 in which each of the p-layer, the i-layer, and the n-layer is formed; however, the method of continuously forming the p-layer, the i-layer, and the n-layer in each of the individual chambers 173 to 176 may be employed.

In the single wafer type film formation apparatus, an installation area increases, and thereby there is a case where the number of the i-layer film-formation reaction chambers cannot increase.

In this case, by forming the p, i, and n-layers in each reaction chamber, it is possible to increase substantially the number of the i-layer film-formation reaction chamber.

In the foregoing manufacturing method, the i-layer that is an amorphous photoelectric conversion-layer has a film thickness of 2000 to 3000Å, and can be manufactured in a reaction chamber for exclusive use.

Additionally, since a reaction chamber for exclusive use for each of p, i, the and n-layers is used, an indistinct junction caused by impurities in the p-layer being diffused in an i-layer or caused by remaining impurities being doped into a p-layer and an n-layer is not generated, and it is possible to obtain an excellent impurity profile in a pin junction structure.

In contrast, since the film thickness of i-layer that is a crystalline photoelectric conversion-layer is required such as 15000 to 25000Å so as to be one-digit thicker than that of an amorphous photoelectric conversion-layer, a batch type or single wafer type reaction chamber, in which a plurality of substrates is disposed and simultaneously processed in order to improve productivity is advantageous.

However, in the case where the p, i, and n-layers of the crystalline photoelectric conversion-layer are formed in the same reaction chamber, since the processing is performed in the same reaction chamber, there is a problem in that an indistinct junction caused by impurities in the p-layer being diffused in an i-layer or caused by remaining impurities being doped into a p-layer and an n-layer is generated.

The remaining impurities being doped into the p-layer and the n-layer means the component of an impurity gas (dopant) that remains in the chamber and is doped into the other layers, which is caused by using both an impurity gas used for a p-layer (dopant) and an impurity gas used for an n-layer (dopant) in the same chamber.

For example, in the case of forming a p-layer on a next substrate after forming an n-layer on a substrate in the same chamber, there is a concern that impurities in the n-layer remain and the impurities is doped into the p-layer of the next substrate.

### SUMMARY OF THE INVENTION

The invention was conceived in view of the above-described circumstances and it is a first object thereof to provide a photoelectric conversion device manufacturing method, in which a first-photoelectric conversion unit and a second-photoelectric conversion unit which are a pin-type are sequentially stacked in layers on a insulative-transparent substrate having a transparent-electroconductive film, and at least i-layer constituting the second-photoelectric conversion unit includes a crystalline-silicon-based thin film. In the method, an indistinct junction caused by impurities in the n-layer being diffused in the p-layer constituting the second-photoelectric conversion unit, impurities in the p-layer being excessively diffused in an i-layer, impurities in the n-layer being diffused in the i-layer constituting the second-photoelectric conversion unit, or remaining impurities in the n-layer being doped into a p-i junction face, is not generated, and the photoelectric conversion device has an excellent power generation capability.

Additionally, a second object of the present invention is to provide a photoelectric conversion device having an excellent power generation capability.

Furthermore, a third object of the present invention is to provide a manufacturing system which can form a photoelectric conversion device in which an indistinct junction caused by impurities in the n-layer being diffused in the p-layer constituting the second-photoelectric conversion unit, impurities in the p-layer being excessively diffused in an i-layer, impurities in the n-layer being diffused in the i-layer constituting the second-photoelectric conversion unit, or remaining impurities in the n-layer being doped into a p-i junction face, is not generated. The photoelectric conversion device has an excellent power generation capability.

A photoelectric conversion device manufacturing method of a first aspect of the present invention includes: continuously forming a first p-type semiconductor layer, a first i-type semiconductor layer, and a first n-type semiconductor layer, which constitute a first-photoelectric conversion unit, and a second p-type semiconductor layer which constitutes a second-photoelectric conversion unit, in decompression chambers that are different from each other; exposing the second p-type semiconductor layer to an air atmosphere; and forming a second i-type semiconductor layer and a second n-type semiconductor layer, which constitute the second-photoelectric conversion unit, on the second p-type semiconductor layer that was exposed to the air atmosphere, in the same decompression chamber.

It is preferable that the photoelectric conversion device manufacturing method of the first aspect of the present invention further include: exposing the second p-type semiconductor layer that was exposed to the air atmosphere to plasma including a hydrogen radical before forming the second i-type semiconductor layer.

In the photoelectric conversion device manufacturing method of the first aspect of the present invention, it is preferable that, when exposing the second p-type semiconductor layer to plasma including the hydrogen radical, a hydrogen gas be used.

In the photoelectric conversion device manufacturing method of the first aspect of the present invention, it is preferable that the second p-type semiconductor layer be exposed to plasma including a hydrogen radical in an atmosphere having a dopant gas to be introduced into the second p-type semiconductor layer, before forming the second i-type semiconductor layer.

In the photoelectric conversion device manufacturing method of the first aspect of the present invention, it is preferable that a crystalline-silicon-based thin film be formed as the first n-type semiconductor layer.

It is preferable that the photoelectric conversion device manufacturing method of the first aspect of the present invention further include: forming a third p-type semiconductor layer after forming the second i-type semiconductor layer and the second n-type semiconductor layer.

A photoelectric conversion device of a second aspect of the present invention is formed by the above-described photoelectric conversion device manufacturing method.

A photoelectric conversion device manufacturing system of a third aspect of the present invention includes: a first-film-formation apparatus that forms a first p-type semiconductor layer, a first i-type semiconductor layer, and a first n-type semiconductor layer, which constitute a first-photoelectric conversion unit, and a second p-type semiconductor layer which constitutes a second-photoelectric conversion unit, and that includes a plurality of plasma-CVD reaction chambers which are connected so as to maintain a reduced-pressure atmosphere; a discharge apparatus that transfers the substrate on which the second p-type semiconductor layer is formed, to an air atmosphere; and a second-film-formation apparatus that stores the substrate which was transferred to the air atmosphere, and that includes a plasma-CVD reaction chamber in which a second i-type semiconductor layer and a second n-type semiconductor layer, which constitute the second-photoelectric conversion unit, are formed in a reduced-pressure atmosphere.

In the photoelectric conversion device manufacturing system of the third aspect of the present invention, it is preferable that the second-film-formation apparatus expose the second p-type semiconductor layer that was exposed to the air atmosphere, to plasma including a hydrogen radical before forming the second i-type semiconductor layer.

In the photoelectric conversion device manufacturing system of the third aspect of the present invention, it is preferable that the second-film-formation apparatus have a gas-introduction section introducing a hydrogen gas thereinto; and the second p-type semiconductor layer be subjected to plasma including the hydrogen radical by use of the hydrogen gas that is introduced by the gas-introduction section.

In the photoelectric conversion device manufacturing system of the third aspect of the present invention, it is preferable that the second p-type semiconductor layer be subjected to plasma including the hydrogen radical in the plasma-CVD reaction chamber in which the second i-type semiconductor layer and the second n-type semiconductor layer are formed.

In the photoelectric conversion device manufacturing system of the third aspect of the present invention, it is preferable that the second p-type semiconductor layer be subjected to plasma including a hydrogen radical in an atmosphere having a dopant gas to be introduced into the second p-type semiconductor layer, before forming the second i-type semiconductor layer.

In the photoelectric conversion device manufacturing system of the third aspect of the present invention, it is preferable that the first-film-formation apparatus form a crystalline-silicon-based thin film as the first n-type semiconductor layer.

In the photoelectric conversion device manufacturing system of the third aspect of the present invention, it is preferable that a third p-type semiconductor layer be formed after forming the second i-type semiconductor layer and the second n-type semiconductor layer.

### Effects of the Invention

According to the method of the present invention for manufacturing a photoelectric conversion device, since the plasma-CVD reaction chamber, in which the first p-type semiconductor layer, the first i-type semiconductor layer, the first n-type semiconductor layer of the first-photoelectric conversion unit, or the second i-type semiconductor layer of the second-photoelectric conversion unit is formed, is different from the plasma-CVD reaction chamber in which the second p-type semiconductor layer of the second-photoelectric conversion unit is formed, it is possible to suppress an n-type impurity from being diffused in the second p-type semiconductor layer which constitutes the second-photoelectric conversion unit and suppress a p-type impurity from being excessively diffused in the second i-type semiconductor layer.

In addition, since the second i-type semiconductor layer is not immediately formed after the second p-type semiconductor layer is formed, controlling the p-i junction becomes easy.

Also, due to the p-type semiconductor layer of the second-photoelectric conversion unit being exposed to an air atmosphere, a crystal core is generated which is caused by OH being adhered to the top face of the p-type semiconductor layer or part of the surface of the p-layer being oxidized, and the crystallization rate of the i-type semiconductor layer of the second-photoelectric conversion unit composed of a crystalline-silicon-based thin film increases.

Additionally, since the photoelectric conversion device of the present invention is formed by the above-described photoelectric conversion device manufacturing method, an excellent impurity profile is obtained in the pin junction structure.

Because of this, it is possible to obtain an excellent capability of a thin-film photoelectric conversion device while an indistinct junction is not generated.

Furthermore, according to the photoelectric conversion device of the present invention manufacturing system, the first p-type semiconductor layer, the first i-type semiconductor layer, the first n-type semiconductor layer of the first-photoelectric conversion unit, and the second p-type semiconductor layer of the second-photoelectric conversion unit are formed in the first-film-formation apparatus. Additionally, the second i-type semiconductor layer and the second n-type semiconductor layer of the second-photoelectric conversion unit are formed in the second-film-formation apparatus.

Consequently, it is possible to suppress an n-type impurity from being diffused in the second p-type semiconductor layer which constitutes the second-photoelectric conversion unit and suppress a p-type impurity from being excessively diffused in the second i-type semiconductor layer.

In addition, since the second i-type semiconductor layer is not immediately formed after the second p-type semiconductor layer is formed, controlling the p-i junction becomes easy.

Therefore, it is possible to manufacture a photoelectric conversion device having an excellent capability.

### BRIEF DESCRIPTION OF THE DRAWINGS

FIG. 1A is a cross-sectional view illustrating a photoelectric conversion device manufacturing method related to the present invention.
FIG. 1B is a cross-sectional view illustrating the photoelectric conversion device manufacturing method related to the present invention.
FIG. 1C is a cross-sectional view illustrating the photoelectric conversion device manufacturing method related to the present invention.
FIG. 2 is a cross-sectional view showing an example of layer structure of a photoelectric conversion device related to the present invention.
FIG. 3 is a schematic diagram showing a first manufacturing system related to the present invention which manufactures a photoelectric conversion device.
FIG. 4 is a schematic diagram showing a second manufacturing system related to the present invention which manufactures a photoelectric conversion device.
FIG. 5 is a chart showing the relationship between an electrical-current density and a voltage of photoelectric conversion devices of experimental examples 1 to 6.
FIG. 6 is a chart showing the relationship between an exposure time of a p-layer to an air atmosphere and photoelectric conversion efficiency of photoelectric conversion devices of experimental examples 1 to 6.
FIG. 7 is a chart showing the relationship between an exposure time of a p-layer to an air atmosphere and a short-circuited current of photoelectric conversion devices of experimental examples 1 to 6.
FIG. 8 is a chart showing the relationship between an exposure time of a p-layer to an air atmosphere and an open voltage of photoelectric conversion devices of experimental examples 1 to 6.
FIG. 9 is a chart showing the relationship between an exposure time of a p-layer to an air atmosphere and the fill factor of photoelectric conversion devices of experimental examples 1 to 6.
FIG. 10 is a chart showing the relationship between an electrical-current density and a voltage of photoelectric conversion devices of experimental examples 7 to 11.
FIG. 11 is a chart showing the relationship between an exposure time of a p-layer to an air atmosphere and photoelectric conversion efficiency of photoelectric conversion devices of experimental examples 7 to 11.
FIG. 12 is a chart showing the relationship between an exposure time of a p-layer to an air atmosphere and a short-circuited current of photoelectric conversion devices of experimental examples 7 to 11.
FIG. 13 is a chart showing the relationship between an exposure time of a p-layer to an air atmosphere and an open voltage of photoelectric conversion devices of experimental examples 7 to 11.
FIG. 14 is a chart showing the relationship between an exposure time of a p-layer to an air atmosphere and the fill factor of photoelectric conversion devices of experimental examples 7 to 11.
FIG. 15 is a cross-sectional view showing an example of a conventional photoelectric conversion device.
FIG. 16A is a cross-sectional view illustrating a conventional photoelectric conversion device manufacturing method.
FIG. 16B is a cross-sectional view illustrating a conventional photoelectric conversion device manufacturing method.
FIG. 16C is a cross-sectional view illustrating a conventional photoelectric conversion device manufacturing method.
FIG. 17 is a schematic diagram showing an example of conventional manufacturing systems which manufacture a photoelectric conversion device.
FIG. 18 is a schematic diagram showing an example of conventional manufacturing systems which manufacture a photoelectric conversion device.

### DESCRIPTION OF THE PREFERRED EMBODIMENTS

Hereinafter, a photoelectric conversion device manufacturing method of an embodiment related to the present invention will be described with reference to drawings.

In the embodiment described below, a tandem-type photoelectric conversion device, which is configured so that a first-photoelectric conversion unit that is an amorphous silicon type photoelectric conversion device and a second-photoelectric conversion unit that is a microcrystalline silicon type photoelectric conversion device are stacked in layers, will be described.

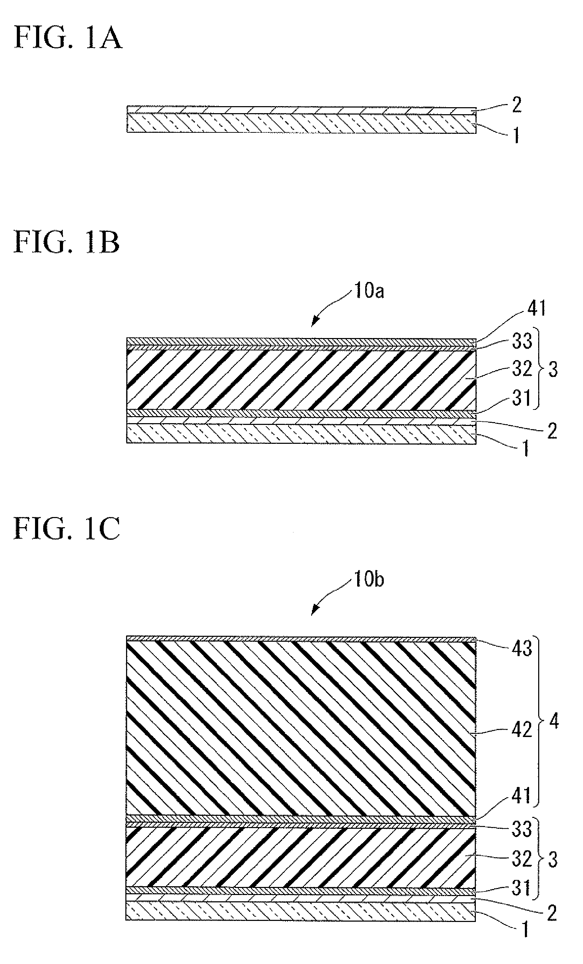

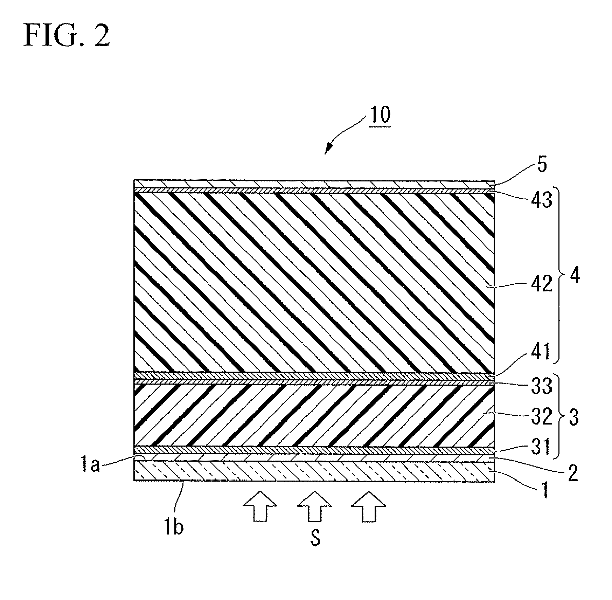

FIGS. 1A to 1C are cross-sectional views illustrating a photoelectric conversion device manufacturing method of the present invention, and FIG. 2 is a cross-sectional view showing the layer structure of a photoelectric conversion device related to the present invention.

Firstly, as shown in FIG. 2, in a photoelectric conversion device 10 which is manufactured by the manufacturing method of the present invention, a first-photoelectric conversion unit 3 and second-photoelectric conversion unit 4 that are pin-type are stacked on a first face 1a (top face) of a substrate 1 in layers in this order, the substrate 1 having optical transparency and an insulation property. Furthermore, a back-face electrode 5 is formed on the second-photoelectric conversion unit 4.

The substrate 1 is composed of an insulation material having an excellent sunlight transparency and durability such as a glass or a transparent resin.

The substrate 1 is provided with a transparent-electroconductive film 2.

An oxide of metal having optical transparency such as ITO (Indium Tin Oxide), SnO₂, ZnO, or the like is adopted as the material of the transparent-electroconductive film 2.

The transparent-electroconductive film 2 is formed on the substrate 1 using a vacuum deposition method or a sputtering method.

In the photoelectric conversion device 10, as indicated by the open arrow of FIG. 2, sunlight S is incident to a second face 1b of the substrate 1.

In addition, the first-photoelectric conversion unit 3 has a pin structure in which a p-type semiconductor layer (p-layer, first p-type semiconductor layer) 31, substantially intrinsic i-type semiconductor layer (i-layer, first i-type semiconductor layer) 32, and an n-type semiconductor layer (n-layer, first n-type semiconductor layer) 33 are stacked in layers.

That is, the first-photoelectric conversion unit 3 is formed by stacking the p-layer 31, the i-layer 32, and the n-layer 33 in this order.

The first-photoelectric conversion unit 3 is composed of an amorphous-silicon based material.

In the first-photoelectric conversion unit 3, for example, the thickness of the p-layer 31 is 90Å, the thickness of the i-layer 32 is 2500Å, and the thickness of the n-layer 33 is 300Å.

Plasma-CVD reaction chambers, in which the p-layer 31, the i-layer 32, and the n-layer 33 of the first-photoelectric conversion unit 3 are formed, are different from each other.

In addition, in the first-photoelectric conversion unit 3, the p-layer 31 and the i-layer 32 can be formed of amorphous silicon, and the n-layer 33 can be formed of amorphous silicon including a crystalline material (referred to as microcrystalline silicon).

Additionally, the second-photoelectric conversion unit 4 has a pin structure in which a p-type semiconductor layer (p-layer, second p-type semiconductor layer) 41, substantially intrinsic i-type semiconductor layer (i-layer, second i-type semiconductor layer) 42, and an n-type semiconductor layer (n-layer, second n-type semiconductor layer) 43 are stacked in layers.

That is, the second-photoelectric conversion unit 4 is formed by stacking the p-layer 41, the i-layer 42, and the n-layer 43 in this order.

The second-photoelectric conversion unit 4 is composed of a silicon based material including a crystalline material.

In the second-photoelectric conversion unit 4, for example, the thickness of the p-layer 41 is 100Å, the thickness of the i-layer 42 is 15000Å, and the thickness of the n-layer 43 is 150Å.

Regarding the second-photoelectric conversion unit 4, a plasma-CVD reaction chamber in which the p-layer 41 is formed is different from the plasma-CVD reaction chamber in which the i-layer 42 and the n-layer 43 are formed.

The i-layer 42 and the n-layer 43 are formed in the same plasma-CVD reaction chamber.

The back-face electrode 5 may be composed of a light-reflection conductive film such as Ag (silver) or A1 (aluminum).

The back-face electrode 5 can be formed using a sputtering method or a deposition method.

Additionally, a layered structure, in which a layer composed of a conductive-oxidative product such as ITO, SnO₂, or ZnO is formed between the n-type semiconductor layer (n-layer) 43 of the second-photoelectric conversion unit 4 and the back-face electrode 5, may be adopted as the back-face electrode 5.

Next, a method for manufacturing the photoelectric conversion device 10 having the above-described constitution will be described.

Firstly, as shown in FIG. 1A, an insulative-transparent substrate 1 on which a transparent-electroconductive film 2 is formed is prepared.

Subsequently, as shown in FIG. 1B, a p-type semiconductor layer 31, an i-type silicon layer (amorphous silicon layer) 32, an n-type semiconductor layer 33, and a p-type semiconductor layer 41 are formed on the transparent-electroconductive film 2 formed on the insulative-transparent substrate 1.

Here, plasma-CVD reaction chambers in which the p-layer 31, the i-layer 32, the n-layer 33, and the p-layer 41 are formed are different from each other.

That is, a first intermediate part 10a of the photoelectric conversion device in which the p-type semiconductor layer 41 constituting a second-photoelectric conversion unit 4 is provided is formed on the n-type semiconductor layer 33 of the first-photoelectric conversion unit 3.

The p-type semiconductor layer 31 is formed in the individual reaction chamber using a plasma CVD method.

The p-layer 31 composed of amorphous silicon (a-Si) can be formed under conditions in which, for example, the substrate temperature is 170 to 200°C, the frequency of the power source is 13.56MHz, the internal pressure of the reaction chamber is 70 to 120 Pa, and the flow rates of the reactive gases are 300 sccm of monosilane (SiH₄), 2300 sccm of hydrogen (H₂), 180 sccm of diborane (B₂H₆/H₂) using hydrogen as a diluted gas, and 500 sccm of methane (CH₄).

Also, the i-type silicon layer (amorphous silicon layer) 32 is formed in the individual reaction chamber using a plasma CVD method.

The i-layer composed of amorphous silicon (a-Si) can be formed under conditions in which, for example, the substrate temperature is 170 to 200°C, the frequency of the power source is 13.56MHz, the internal pressure of the reaction chamber is 70 to 120 Pa, and the flow rate of the reactive gas is 1200 sccm of monosilane (SiH₄).

Moreover, the n-type semiconductor layer 33 is formed in the individual reaction chamber using a plasma CVD method.

The n-layer composed of amorphous silicon (a-Si) can be formed under conditions in which, for example, the substrate temperature is 170 to 200°C, the frequency of the power source is 13.56MHz, the internal pressure of the reaction chamber is 70 to 120 Pa, and the flow rate of the reactive gas is 200 sccm of phosphine (PH₃/H₂) using hydrogen as a diluted gas.

Furthermore, the p-type semiconductor layer 41 of the second-photoelectric conversion unit 4 is formed in the individual reaction chamber using a plasma CVD method.

The p-layer composed of microcrystalline silicon (µc-Si) can be formed under conditions in which, for example, the substrate temperature is 170 to 200°C, the frequency of the power source is 13.56MHz, the internal pressure of the reaction chamber is 500 to 1200 Pa, and the flow rates of the reactive gases are 100 sccm of monosilane (SiH₄), 25000 sccm of hydrogen (H₂), and 50 sccm of diborane (B₂H₆/H₂) using hydrogen as a diluted gas.

Continuously, after the p-type semiconductor layer 41 of the second-photoelectric conversion unit 4 is exposed to an air atmosphere, an i-type silicon layer (crystalline-silicon layer) 42 and an n-type semiconductor layer 43 which constitute the second-photoelectric conversion unit 4 are formed on the p-type semiconductor layer 41 that was exposed to an air atmosphere in the same plasma-CVD reaction chamber as shown in FIG. 1C.

That is, a second intermediate part 10b of the photoelectric conversion device in which the second-photoelectric conversion unit 4 is provided is formed on the first-photoelectric conversion unit 3.

Consequently, by forming a back-face electrode 5 on the n-type semiconductor layer 43 of the second-photoelectric conversion unit 4, the photoelectric conversion device 10 is obtained as shown in FIG. 2.

The i-type silicon layer (crystalline-silicon layer) 42 is formed using a plasma CVD method in the same reaction chamber as the reaction chamber in which the n-type semiconductor layer 43 is formed.

The i-layer composed of microcrystalline silicon (µc-Si) can be formed under conditions in which, for example, the substrate temperature is 170 to 200°C, the frequency of the power source is 13.56MHz, the internal pressure of the reaction chamber is 500 to 1200 Pa, and the flow rates of the reactive gases are 180 sccm of monosilane (SiH₄) and 27000 sccm of hydrogen (H₂).

The n-type semiconductor layer 43 is formed using a plasma CVD method in the same reaction chamber as the reaction chamber in which the i-type silicon layer (crystalline-silicon layer) 42 is formed.

The n-layer composed of microcrystalline silicon (µc-Si) can be formed under conditions in which, for example, the substrate temperature is 170 to 200°C, the frequency of the power source is 13.56MHz, the internal pressure of the reaction chamber is 500 to 1200 Pa, and the flow rates of the reactive gases are 180 sccm of monosilane (SiH₄), 27000 sccm of hydrogen (H₂), and 200 sccm of phosphine (PH₃/H₂) using hydrogen as a diluted gas.

Subsequently, a system manufacturing the photoelectric conversion device 10 will be described with reference to drawings.

The photoelectric conversion device manufacturing system related to the present invention can be separated into a first manufacturing system and a second manufacturing system.

The first manufacturing system has a structure in which a so-called in-line type first-film-formation apparatus, an exposure apparatus in which a p-layer of a second-photoelectric conversion unit is exposed to an air atmosphere, and a so-called batch type second-film-formation apparatus are arranged in order.

The in-line type first-film-formation apparatus has a structure in which a plurality of film-formation reaction chambers referred to as chamber are disposed so as to be linearly connected.

In the first-film-formation apparatus, each of layers, that is, the p-type semiconductor layer 31, the i-type silicon layer (amorphous silicon layer) 32, the n-type semiconductor layer 33 which constitute the first-photoelectric conversion unit 3, and the p-type semiconductor layer 41 of the second-photoelectric conversion unit 4, is separately formed.

In the second-film-formation apparatus, each of layers, that is, the i-type silicon layer (crystalline-silicon layer) 42 and the n-type semiconductor layer 43 which constitute the second-photoelectric conversion unit 4, is formed on a plurality of substrates in the same film-formation reaction chamber at the same time.

Additionally, the second manufacturing system has a structure in which a so-called in-line type first-film-formation apparatus, an exposure apparatus in which a p-layer of a second-photoelectric conversion unit is exposed to an air atmosphere, and a so-called single wafer type second-film-formation apparatus are arranged in order.

The first-film-formation apparatus and the exposure apparatus of the second manufacturing system have the same structure as the first-film-formation apparatus and the exposure apparatus of the first manufacturing system.

In the second-film-formation apparatus, the second-photoelectric conversion unit 104 is formed using a plurality of film-formation reaction chambers for exclusive use for forming the i-type silicon layer (crystalline-silicon layer) 42 and the n-type semiconductor layer 43.

### First Manufacturing System

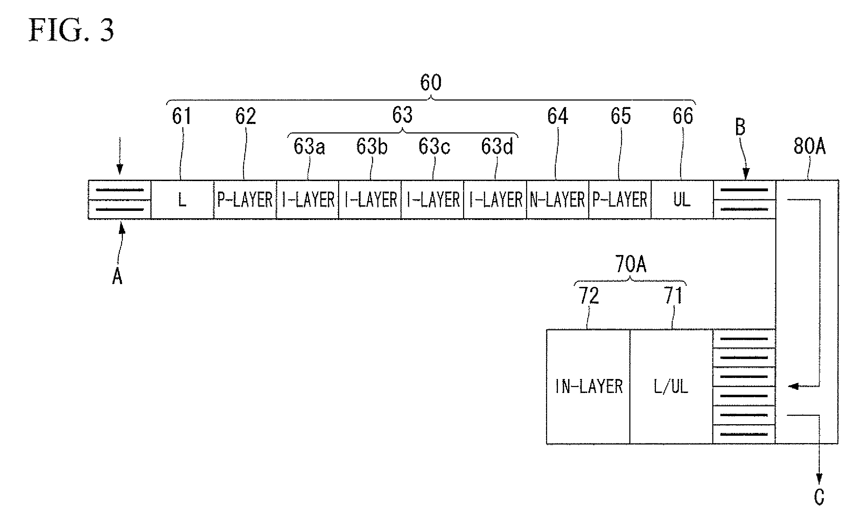

Firstly, the first manufacturing system related to the present invention for manufacturing a photoelectric conversion device is shown in FIG. 3.

As shown in FIG. 3, the first manufacturing system is constituted of a first-film-formation apparatus 60, a second-film-formation apparatus 70A, and an exposure apparatus 80A exposing the substrate that was processed in the first-film-formation apparatus 60, to an air atmosphere, and transferring the substrate to the second-film-formation apparatus 70A.

In the first-film-formation apparatus 60 of the first manufacturing system, a load chamber (L: Lord) 61 to which a substrate is initially transferred and which reduces the internal pressure thereof is disposed.

In other cases, a heating chamber heating the substrate so as to cause the temperature thereof to be a constant temperature in accordance with a film formation processing may be provided at a stage subsequent to the load chamber (L: Lord) 61.

Continuously, a p-layer film-formation reaction chamber (decompression chamber) 62 in which the p-type semiconductor layer 31 of the first-photoelectric conversion unit 3 is formed, an i-layer film-formation reaction chambers (decompression chamber) 63 in which the i-type silicon layer (amorphous silicon layer) 32 is formed, an n-layer film-formation reaction chamber (decompression chamber) 64 in which the n-type semiconductor layer 33 is formed, and a p-layer film-formation reaction chamber (decompression chamber) 65 in which the p-type semiconductor layer 41 of the second-photoelectric conversion unit 4 is formed, are continuously and linearly arranged.

Finally, an unload chamber (UL: Unlord, discharge apparatus) 66 returning from a reduced-pressure atmosphere to an air atmosphere and transferring the substrate from the unload chamber is connected to the p-layer film-formation reaction chamber 65.

Because of this, it is possible to transfer the substrate between the load chamber (L: Lord) 61, the p-layer film-formation reaction chamber 62, the i-layer film-formation reaction chambers 63, the n-layer film-formation reaction chamber 64, the p-layer film-formation reaction chamber 65, and the unload chamber (UL: Unlord) 66 while maintaining a reduced-pressure atmosphere.

In this case, at the A point indicated in FIG. 3, as shown in FIG. 1A, an insulative-transparent substrate 1 on which a transparent-electroconductive film 2 is formed is prepared.

Additionally, at the B point indicated in FIG. 3, as shown in FIG. 1B, the first intermediate part 10a of the photoelectric conversion device in which the p-type semiconductor layer 31, the i-type silicon layer (amorphous silicon layer) 32, and the n-type semiconductor layer 33, which constitute the first-photoelectric conversion unit 3, and the p-type semiconductor layer 41 of the second-photoelectric conversion unit 4 are provided on the transparent-electroconductive film 2 is formed.

Moreover, the exposure apparatus 80A of the first manufacturing system is a rack used for temporarily setting or storing the first intermediate part 10a in which a top face of the p-type semiconductor layer 41 is exposed to an atmosphere.

Also, the exposure apparatus 80A may be a substrate storage holder used for handling a plurality of first intermediate parts 10a as an integrated group.

Additionally, the exposure apparatus 80A may have a transfer mechanism (air-atmosphere transfer mechanism) transferring the first intermediate part 10a from the first-film-formation apparatus 60 toward the second-film-formation apparatus 70A in an air atmosphere.

Also, in the case where the first manufacturing system is operating in a clean room, the exposure apparatus 80A exposes the first intermediate part 10a to an atmosphere in a clean room in which the humidity, temperature, number of particles per unit volume, or the like is controlled.

Additionally, the second-film-formation apparatus 70A of the first manufacturing system has a load-unload chamber (L/UL) 71 and an in-layer film-formation reaction chamber 72.

The load-unload chamber (L/UL) 71 transfers the first intermediate part 10a of the photoelectric conversion device, which was processed in the first-film-formation apparatus 60, thereto, reduces the internal pressure after the substrate is transferred, and returns the reduced-pressure atmosphere to an air atmosphere when the substrate is transferred from the load-unload chamber 71.

The in-layer film-formation reaction chamber 72 is subsequently connected to the load-unload chamber (L/UL) 71.

In the in-layer film-formation reaction chamber 72, the i-type silicon layer (crystalline-silicon layer) 42 and the n-type semiconductor layer 43 of the second-photoelectric conversion unit 4 are sequentially formed on the p-type semiconductor layer 41 of the second-photoelectric conversion unit 4 in the same reaction chamber.

In addition, a plurality of substrates is subjected to the film formation processing at the same time.

Here, at the C point indicated in FIG. 3, as shown in FIG. 1C, a second intermediate part 10b of the photoelectric conversion device in which the second-photoelectric conversion unit 4 is provided is formed on the first-photoelectric conversion unit 3.

Additionally, as shown in FIG. 3, in the in-line type first-film-formation apparatus 60, two substrates are subjected to the film formation processing at the same time, and the i-layer film-formation reaction chambers 63 are constituted of four reaction chambers 63a, 63b, 63c, and 63d.

Also, in FIG. 3, the batch type second-film-formation apparatus 70A is configured to process six substrates at the same time.

### Second Manufacturing System

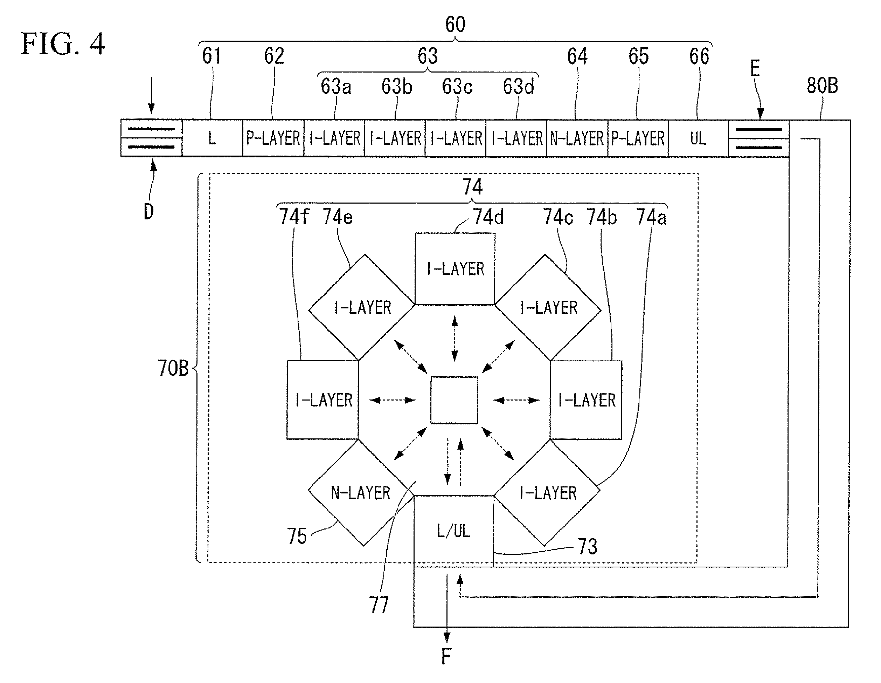

Next, the second manufacturing system related to the present invention for manufacturing a photoelectric conversion device is shown in FIG. 4.

As shown in FIG. 4, the second manufacturing system is constituted of a first-film-formation apparatus 60, a second-film-formation apparatus 70B, and an exposure apparatus 80B exposing the substrate that was processed in the first-film-formation apparatus 60, to an air atmosphere, and transferring the substrate to the second-film-formation apparatus 70B.

Similarly to the first-film-formation apparatus 60 of the first manufacturing system, the first-film-formation apparatus 60 of the second manufacturing system has the load chamber (L: Lord) 61 which reduces the internal pressure thereof after the substrate is transferred to the load chamber (L: Lord) 61.

In other cases, a heating chamber heating the substrate so as to cause the temperature thereof to be a constant temperature in accordance with a processing may be provided at a stage subsequent to the load chamber (L: Lord) 61.

Continuously, the p-layer film-formation reaction chamber 62 in which the p-type semiconductor layer 31 of the first-photoelectric conversion unit 3 is formed, the i-layer film-formation reaction chambers 63 in which the i-type silicon layer (amorphous silicon layer) 32 is formed, the n-layer film-formation reaction chamber 64 in which the n-type semiconductor layer 33 is formed, and the p-layer film-formation reaction chamber 65 in which the p-type semiconductor layer 41 of the second-photoelectric conversion unit 4 is formed, are continuously and linearly arranged.

Finally, an unload chamber (UL: Unlord) 66 returning form a reduced-pressure atmosphere to an air atmosphere and transferring the substrate from the unload chamber is connected to the p-layer film-formation reaction chamber 65.

Because of this, it is possible to transfer the substrate between the load chamber (L: Lord) 61, the p-layer film-formation reaction chamber 62, the i-layer film-formation reaction chambers 63, the n-layer film-formation reaction chamber 64, the p-layer film-formation reaction chamber 65, and the unload chamber (UL: Unlord) 66 while maintaining a reduced-pressure atmosphere.

In this case, at the D point indicated in FIG. 4, as shown in FIG. 1A, an insulative-transparent substrate 1 on which a transparent-electroconductive film 2 is formed is prepared.

Additionally, at the E point indicated in FIG. 4, as shown in FIG. 1B, the first intermediate part 10a of the photoelectric conversion device, in which each layer of the p-type semiconductor layer 31, the i-type silicon layer (amorphous silicon layer) 32, and the n-type semiconductor layer 33, which constitute the first-photoelectric conversion unit 3, and the p-type semiconductor layer 41 of the second-photoelectric conversion unit 4, is provided on the transparent-electroconductive film 2 is formed.

In addition, the structure of the exposure apparatus 80B of the second manufacturing system is the same as the exposure apparatus 80A of the first manufacturing system.

Additionally, the exposure apparatus 80B may have a transfer mechanism (air-atmosphere transfer mechanism) transferring the first intermediate part 10a from the first-film-formation apparatus 60 toward the second-film-formation apparatus 70B in an air atmosphere.

Additionally, the second-film-formation apparatus 70B of the second manufacturing system has a load-unload chamber (L/UL) 73, i-layer film-formation reaction chambers 74, an n-layer film-formation reaction chamber 75, and an intermediate chamber 77, which are arranged in a circular shape.

The load-unload chamber (L/UL) 73 reduces the internal pressure thereof after the first intermediate part 10a of the photoelectric conversion device, which was processed in the first-film-formation apparatus 60, is transferred thereto, and the load-unload chamber (L/UL) 73 returns from the reduced-pressure atmosphere to an air atmosphere when the substrate is transferred from the load-unload chamber (L/UL) 73.

Continuously, the substrate is transferred to the intermediate chamber 77 via the load-unload chamber (L/UL) 73.

Also, the substrate is transferred between the intermediate chamber 77 and the p-layer film-formation reaction chambers 74, between the intermediate chamber 77 and the i-layer film-formation reaction chamber 75, and between the intermediate chamber 77 and the n-layer film-formation reaction chamber 76.

In the i-layer film-formation reaction chambers 74, the i-type silicon layer (crystalline-silicon layer) 42 of the second-photoelectric conversion unit 4 is formed on the p-type semiconductor layer 41 of the second-photoelectric conversion unit 4.

In the n-layer film-formation reaction chamber 75, the n-type semiconductor layer 43 is formed on the i-type silicon layer (crystalline-silicon layer) 42.

In each of the i-layer film-formation reaction chamber 74 and the n-layer film-formation reaction chamber 75, one layer of the i-type silicon layer 42 and the n-type semiconductor layer 43 is formed on one substrate.

In addition, in order to stack the i-type silicon layer 42 and the n-type semiconductor layer 43 in layers, a transfer device (not shown in the figure) that is provided at the intermediate chamber 77 transfers the substrate to each of the reaction chambers 73 and 74, and transfers the substrate from each of the reaction chambers 174, 175 and 176.

In other cases, the second-film-formation apparatus 70B may have a heating chamber heating the substrate so as to cause the temperature thereof to be a constant temperature in accordance with a film formation processing.

In this case, at the F point indicated in FIG. 4, as shown in FIG. 1C, a second intermediate part 10b of the photoelectric conversion device, on which a second-photoelectric conversion unit 4 is provided on the first-photoelectric conversion unit 3, is formed.

Additionally, in FIG. 4, in the in-line type first-film-formation apparatus 60, two substrates are simultaneously subjected to the film formation processing, and i-layer film-formation reaction chambers 63 are constituted of four reaction chambers 63a, 63b, 63c, and 63d.

Moreover, in FIG. 4, seven substrates are simultaneously processed in reaction chambers, respectively in the single wafer type second-film-formation apparatus 70B.

Consequently, in FIG. 4, the i-layer film-formation reaction chambers 74 are constituted of six reaction chambers 74a, 74b, 74c, 74d, 74e, and 74f.

Since the film thickness of the i-type silicon layer 42 constituting the second-photoelectric conversion unit 4 is greater than that of the n-type semiconductor layer 43, the time to form the i-type silicon layer 42 is longer than that of the n-type semiconductor layer 43.

Because of this, the throughput of production of the photoelectric conversion device is determined depending on the number of the i-layer film-formation reaction chambers 74.

As described above, in the single wafer type second-film-formation apparatus 70B, since the i-layer film-formation reaction chambers 74 are six reaction chambers, it is possible to simultaneously form the i-type silicon layer 42 on a plurality of the substrates, and the throughput is improved.

According to the above-described photoelectric conversion device manufacturing method, in the first-film-formation apparatus 60, the p-layer of the second-photoelectric conversion unit 4 that is a crystalline photoelectric conversion device is formed above the p-layer, the i-layer, and the n-layer of the first-photoelectric conversion unit 3 that is the amorphous photoelectric conversion device.

Moreover, the i-layer and the n-layer of the second-photoelectric conversion unit 4 are formed in the second-film-formation apparatuses 70A and 70B.

For this reason, it is possible to easily control distribution of the crystallization rate of the i-layer of the second-photoelectric conversion unit 4.

Additionally, in the present invention, when the i-type silicon layer (crystalline-silicon layer) 42 and the n-type semiconductor layer 43 which constitute the second-photoelectric conversion unit 4 are formed on the p-type semiconductor layer 41 that is exposed to an air atmosphere, it is desirable that the p-layer 41 of the second-photoelectric conversion unit 4, which is exposed to an air atmosphere, be exposed to plasma including a hydrogen radical before the i-layer 42 is formed (hydrogen radical plasma processing).

As the hydrogen radical plasma processing, a method is adopted in which a hydrogen radical plasma processing chamber is preliminarily prepared, the substrate on which the p-layer 41 of the second-photoelectric conversion unit 4 is formed is transferred to the plasma processing chamber, and the p-layer 41 is subjected to plasma.

In addition, after the hydrogen radical plasma processing, the i-type silicon layer (crystalline-silicon layer) 42 and the n-type semiconductor layer 43 which constitute the second-photoelectric conversion unit 4 are formed in individual reaction chambers.

On the other hand, as the hydrogen radical plasma processing, the hydrogen radical plasma processing and the processing of forming the i-layer 42 and the n-layer 43 of the second-photoelectric conversion unit 4 may be continuously performed in the same reaction chamber.

Here, in the case where the processing of forming the i-layer 42 and the n-layer 43 of the second-photoelectric conversion unit 4 and the hydrogen radical plasma processing are continuously performed in the same reaction chamber, due to exposing inner walls of the reaction chamber to plasma including a hydrogen radical before forming the i-layer 42, remaining impurity gas PH₃ which was introduced into the reaction chamber at the time of previous formation of an n-layer 43 is decomposed, and it is possible to remove it.

For this reason, even if the film formation processing for the i-layer 42 and the n-layer 43 of the second-photoelectric conversion unit 4 is repeatedly performed in the same processing chamber, an excellent impurity profile is obtained, and it is possible to obtain a stacked-thin-film photoelectric conversion device with an excellent power generation efficiency.

Additionally, in the hydrogen radical plasma processing in which the p-layer 41 of the second-photoelectric conversion unit 4 is subjected thereto, it is desirable that H₂ gas (hydrogen gas) be used as a processing gas.

That is, when generating a hydrogen radical plasma, due to applying high-frequency such as 13.5MHz, 27MHz, or 40MHz between electrodes in the processing chamber in a state where H₂ is introduced into the processing chamber, it is possible to effectively generate the plasma.

In addition, in the above-described second-film-formation apparatuses 70A and 70B, a gas box (gas-introduction section) and gas lines (gas-introduction section) are provided which supply H₂ gas used for the hydrogen radical plasma processing to the processing chamber (reaction chamber).

Additionally, a mass-flow controller (gas-introduction section) is connected to the processing chamber, the flow rate of H₂ gas that is supplied through the gas box and the gas line is controlled, and the gas of the controlled flow rate is supplied to the processing chamber.

When the hydrogen radical plasma processing is performed in the above-described manner, since stilly reaction is generated compared with an O radical, an effect is obtained in that the top face of the p-layer 41 of the second-photoelectric conversion unit 4 is activated without damaging a lower layer.

Therefore, it is possible to activate the top face of the p-layer 41 of the second-photoelectric conversion unit 4, and it is possible to effectively generate a crystal of the i-layer 42 and the n-layer 43 of the second-photoelectric conversion unit 4, which are stacked thereon in layers.

even if the second-photoelectric conversion unit 4 is formed on a substrate having a large-area, it is possible to obtain uniform distribution of the crystallization rate.

Additionally, as the n-layer 33 of the first-photoelectric conversion unit 3 and the p-layer 41 of the second-photoelectric conversion unit 4, a layer in which a microcrystalline silicon (µc-Si) is dispersed in an amorphous silicon (a-Si) layer, or a layer in which a microcrystalline silicon (µc-Si) is dispersed in an amorphous silicon oxide (a-SiO) layer is adopted.

However, in order to obtain a uniform crystallization distribution rate that is required for an increase in the size of the substrate, namely, a uniform crystallization distribution rate due to generation of crystal growth core of an i-layer and an n-layer of a crystalline photoelectric conversion-layer, it is preferable that a layer be employed in which a microcrystalline silicon (µc-Si) is dispersed in an amorphous silicon oxide (a-SiO) layer.

As described above, the layer in which a microcrystalline silicon (µc-Si) is dispersed in the amorphous silicon oxide (a-SiO) layer can be adjusted so as to obtain a refractive index that is lower than that of a semiconductor layer of amorphous silicon (a-Si).

For this reason, it is possible for the layer to function as a wavelength-selective reflection film, and improve the conversion efficiency by confining short-wavelength light in a top cell side.

Additionally, irrespective of the presence or absence of an effect that the light is trapped, the layer, in which a microcrystalline silicon (µc-Si) is dispersed in the amorphous silicon oxide (a-SiO) layer, effectively expedites generation of crystal growth core of the i-layer 42 and the n-layer 43 of the second-photoelectric conversion unit 4 due to the hydrogen radical plasma processing, and it is possible to obtain uniform distribution of the crystallization rate even on a substrate having a large-area.

In addition, in the present invention, a crystalline-silicon-based thin film may be formed as an n-layer 33 constituting an first-photoelectric conversion unit 3.

That is, the n-layer 33 composed of microcrystalline silicon and the p-layer 41 of the second-photoelectric conversion unit 4 composed of microcrystalline silicon are formed above the p-layer 31 and the i-layer 32 of the first-photoelectric conversion unit 3 composed of amorphous silicon.

Here, it is desirable that, an amorphous p-layer 31 of the first-photoelectric conversion unit 3, an amorphous i-layer 32 formed on the p-layer 31, a crystalline n-layer 33 formed on the i-layer 32, and the p-layer 41 of the second-photoelectric conversion unit 4 formed on the n-layer 33, be continuously formed without being exposed to an air atmosphere.

Specifically, in the method, in which the p-layer 31, the i-layer 32, and the n-layer 33 of the first-photoelectric conversion unit 3 are formed and thereafter exposed to an air atmosphere, and the p-layer 41, the i-layer 42, and the n-layer 43 of the second-photoelectric conversion unit 4 are thereafter formed, the i-layer 32 of the first-photoelectric conversion unit 3 is deteriorated and the element capability is degraded, due to the length of time for leaving and exposing the substrate to an air atmosphere, due to a temperature, due to an atmosphere, or the like.

Because of this, after the p-layer 31 and the i-layer 32 of the first-photoelectric conversion unit 3 are formed, the crystalline n-layer 33 and the p-layer 41 of the second-photoelectric conversion unit 4 are continuously formed without being exposed to an air atmosphere.

As described above, the substrate is subjected to the hydrogen radical plasma processing, on which the crystalline n-layer 33 and the p-layer 41 of the second-photoelectric conversion unit 4 are formed, in an individual reaction chamber or the same reaction chambers, a crystal core is generated by activating the surface thereof, subsequently, the i-layer 42 and the n-layer 43 of the crystalline second-photoelectric conversion unit 4 are stacked in layers, and it is possible to thereby obtain the stacked-thin-film photoelectric conversion device having an excellent power generation efficiency.

In other cases, an example is shown in FIG. 4 in which the i-layer and the n-layer of the second-photoelectric conversion unit 4 are formed in the individual chambers 74 and 75, respectively; however, a method in which the i-layer and the n-layer are continuously formed in each of individual chambers 74 and 75 may be adopted.

### Experimental examples

Next, according to the photoelectric conversion device manufactured by the photoelectric conversion device manufacturing method related to the present invention, experiments were performed as described below.

The photoelectric conversion device manufactured by each experimental example and the manufacturing condition therefor is as follows.

In all of the experimental examples described below, the photoelectric conversion device was manufactured by use of a substrate having lengths of 1100mm and 1400mm.
(1) In the experimental example described below, the relationship between the length of time a p-layer of a second-photoelectric conversion unit being exposed to an air atmosphere and photoelectric conversion characteristics was evaluated.

### Experimental Example 1

In experimental example 1, a p-layer and an i-layer which are composed of an amorphous silicon (a-Si) based thin film were formed on the substrate as a first-photoelectric conversion unit, an n-layer including microcrystalline silicon (µc-Si) was formed on the i-layer, and a p-layer that includes microcrystalline silicon (µc-Si) and constitutes a second-photoelectric conversion unit was formed.

The layers described above were continuously formed in a vacuum atmosphere, and reaction chambers in which the layers are formed were different from each other.

Thereafter, the p-layer of the second-photoelectric conversion unit was exposed to an air atmosphere, and the p-layer of the second-photoelectric conversion unit was subjected to a hydrogen radical plasma processing.

Subsequently, an i-layer and an n-layer, which constitute the second-photoelectric conversion unit and are composed of microcrystalline silicon (µc-Si), were formed.

In experimental example 1, the p-layer, the i-layer, and the n-layer of the first-photoelectric conversion unit, and the p-layer of second-photoelectric conversion unit were formed by a plasma CVD method.

The reaction chambers in which the p-layer, the i-layer, and the n-layer of the first-photoelectric conversion unit, and the p-layer of the second-photoelectric conversion unit are formed were different from each other.

On the other hand, the i-layer and the n-layer of the second-photoelectric conversion unit were formed in the same reaction chamber using a plasma CVD method.

The p-layer of the first-photoelectric conversion unit having a film thickness of 80Å was formed, under conditions in which the substrate temperature was 170°C, the power source output was 40W, the internal pressure of the reaction chamber was 80 Pa, the E/S (distance between the substrate and a counter electrode) was 20mm, and the flow rates of the reactive gases were 150 sccm of monosilane (SiH₄), 470 sccm of hydrogen (H₂), 45 sccm of diborane (B₂H₆/H₂) using hydrogen as a diluted gas, and 300 sccm of methane (CH₄).

Additionally, a buffer layer having a film thickness of 60Å was formed, under conditions in which the substrate temperature was 170°C, the power source output was 40W, the internal pressure of the reaction chamber was 60 Pa, the E/S was 17mm, and the flow rates of the reactive gases were 150 sccm of monosilane (SiH₄), 1500 sccm of hydrogen (H₂), and 0 sccm to 200 sccm of methane (CH₄).

In addition, the i-layer of the first-photoelectric conversion unit having a film thickness of 1800Å was formed, under conditions in which the substrate temperature was 170°C, the power source output was 40W, the internal pressure of the reaction chamber was 40 Pa, the E/S was 14mm, and the flow rate of the reactive gas was 300 sccm of monosilane (SiH₄).

Furthermore, the n-layer of the first-photoelectric conversion unit having a film thickness of 100Å was formed, under conditions in which the substrate temperature was 170°C, the power source output was 1000W, the internal pressure of the reaction chamber was 800 Pa, the E/S was 14mm, and the flow rates of the reactive gases were 20 sccm of monosilane (SiH₄), 2000 sccm of hydrogen (H₂), and 15 seem of phosphine (PH₃/H₂) using hydrogen as a diluted gas.

Next, the p-layer of the second-photoelectric conversion unit having a film thickness of 150Å was formed, under conditions in which the substrate temperature was 170°C, the power source output was 750W, the internal pressure of the reaction chamber was 1200 Pa, the E/S was 9mm, and the flow rates of the reactive gases were 30 sccm of monosilane (SiH₄), 9000 sccm of hydrogen (H₂), and 12 sccm of diborane (B₂H₆/H₂) using hydrogen as a diluted gas.

Here, the p-layer of the second-photoelectric conversion unit was exposed to an air atmosphere for five minutes.

Continuously, the i-layer of the second-photoelectric conversion unit having a film thickness of 15000Å was formed, under conditions in which the substrate temperature was 170°C, the power source output was 550W, the internal pressure of the reaction chamber was 1200 Pa, the E/S was 9mm, and the flow rates of the reactive gases were 45 sccm of monosilane (SiH₄) and 3150 sccm of hydrogen (H₂).

Furthermore, the n-layer of the second-photoelectric conversion unit having a film thickness of 300Å was formed, under conditions in which the substrate temperature was 170°C, the power source output was 1000W, the internal pressure of the reaction chamber was 800 Pa, the E/S was 14mm, and the flow rates of the reactive gases were 20 sccm of monosilane (SiH₄), 2000 sccm of hydrogen (H₂), and 15 sccm of phosphine (PH₃/H₂) using hydrogen as a diluted gas.

### Experimental Example 2

In this experimental example, in a manner similar to experimental example 1, after the p-layer, the i-layer, and the n-layer of the first-photoelectric conversion unit, and the p-layer of the second-photoelectric conversion unit were formed on the substrate, the p-layer of the second-photoelectric conversion unit was exposed to an air atmosphere for five minutes.

The p-layer was subjected to the hydrogen radical plasma processing for sixty seconds under conditions in which the substrate temperature was 170°C, the power source output was 500W, the internal pressure of the reaction chamber was 400 Pa, and H₂ which serves as a processing gas was 1000 sccm.

Subsequently, in a manner similar to experimental example 1, the i-layer and the n-layer of the second-photoelectric conversion unit were formed.

### Experimental Example 3

In this experimental example, in a manner similar to experimental example 1, after the p-layer, the i-layer, and the n-layer of the first-photoelectric conversion unit, and the p-layer of the second-photoelectric conversion unit were formed on the substrate, the p-layer of the second-photoelectric conversion unit was exposed to an air atmosphere for 22 hours.

Subsequently, in a manner similar to experimental example 1, the i-layer and the n-layer of the second-photoelectric conversion unit were formed.

### Experimental Example 4

In this experimental example, in a manner similar to experimental example 1, after the p-layer, the i-layer, and the n-layer of the first-photoelectric conversion unit, and the p-layer of the second-photoelectric conversion unit were formed on the substrate, the p-layer of the second-photoelectric conversion unit was exposed to an air atmosphere for twenty-two hours.

The p-layer was subjected to the hydrogen radical plasma processing for sixty seconds under conditions in which the substrate temperature was 170°C, the power source output was 500W, the internal pressure of the reaction chamber was 400 Pa, and H₂ which serves as a processing gas was 1000 sccm.

Subsequently, in a manner similar to experimental example 1, the i-layer and the n-layer of the second-photoelectric conversion unit were formed.

### Experimental Example 5

In this experimental example, in a manner similar to experimental example 1, after the p-layer, the i-layer, and the n-layer of the first-photoelectric conversion unit, and the p-layer of the second-photoelectric conversion unit were formed on the substrate, the p-layer of the second-photoelectric conversion unit was exposed to an air atmosphere for 860 hours.

The p-layer was subjected to the hydrogen radical plasma processing for sixty seconds under conditions in which the substrate temperature was 170°C, the power source output was 500W, the internal pressure of the reaction chamber was 400 Pa, and H₂ which serves as a processing gas was 1000 sccm.

Subsequently, in a manner similar to experimental example 1, the i-layer and the n-layer of the second-photoelectric conversion unit were formed.

### Experimental Example 6

In this experimental example, in a manner similar to experimental example 1, the p-layer, the i-layer, and the n-layer of the first-photoelectric conversion unit, and the p-layer of the second-photoelectric conversion unit were formed on the substrate.

In this experimental example 6, the processing for exposing the p-layer to an air atmosphere and the hydrogen radical plasma processing were not performed, thereafter, the i-layer and the n-layer of the second-photoelectric conversion unit were formed in a manner similar to experimental example 1.

The respective film formation conditions for forming layers of the photoelectric conversion devices that were manufactured in experimental examples 1 to 6, were shown in Table 1.

**Table 1**

| PHOTOELECTRIC CONVERSION UNIT | | TEMPERATURE [°C] | OUTPUT [W] | PRESSURE [Pa] | E/S [mm] | FLOW RATES [sccm] | | | | | THICKNESS [A] |
|---|---|---|---|---|---|---|---|---|---|---|---|
| | | | | | | SiH₄ | H₂ | B₂H₆/H₂ | CH₄ | PH₃/H₂ | |
| FIRST | p-LAYER | 170 | 40 | 80 | 20 | 150 | 470 | 45 | 300 | - | 80 |
| | Buffer | 170 | 40 | 60 | 17 | 150 | 1500 | - | 200>0 | - | 60 |
| | i-LAYER | 170 | 40 | 40 | 14 | 300 | - | - | - | - | 1800 |
| | n-LAYER | 170 | 1000 | 800 | 14 | 20 | 2000 | - | - | 15 | 100 |
| SECOND | p-LAYER | 170 | 750 | 1200 | 9 | 30 | 9000 | 12 | - | - | 150 |
| | i-LAYER | 170 | 550 | 1200 | 9 | 45 | 3150 | - | - | - | 15000 |
| | n-LAYER | 170 | 1000 | 800 | 14 | 20 | 2000 | - | | - 15 | 300 |

The output characteristics of the photoelectric conversion devices of experimental examples 1 to 6 which have been manufactured in the above-described manner were measured at a temperature of 25°C by irradiating with light of AM (Air Mass) 1.5 with a light quantity of 100 mW/cm²; and a photoelectric conversion efficiency (η), a short-circuited current (Jsc), an open voltage (Voc), a fill factor (FF), and Ic/Ia (spectral intensity of a crystal / spectral intensity of amorphous in Raman spectrum analysis) were evaluated.

The results were shown in Table 2.

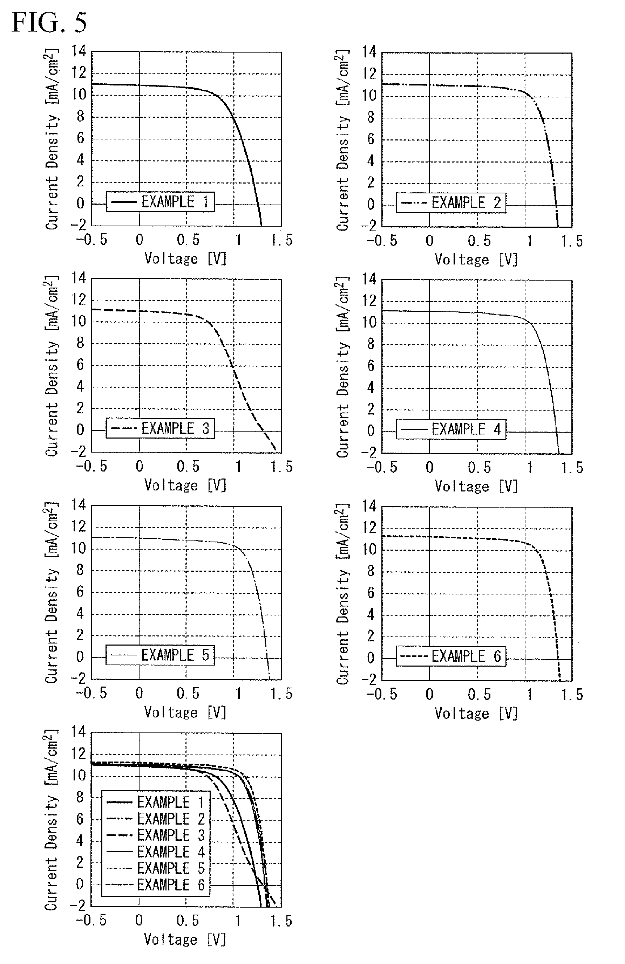

Additionally, in the photoelectric conversion devices of experimental examples 1 to 6, the relationship between an electrical-current density and a voltage is shown in FIG. 5.

FIG. 5 shows characteristic curves indicating experimental examples, respectively, and characteristic curves collectively indicating experimental examples 1 to 6.

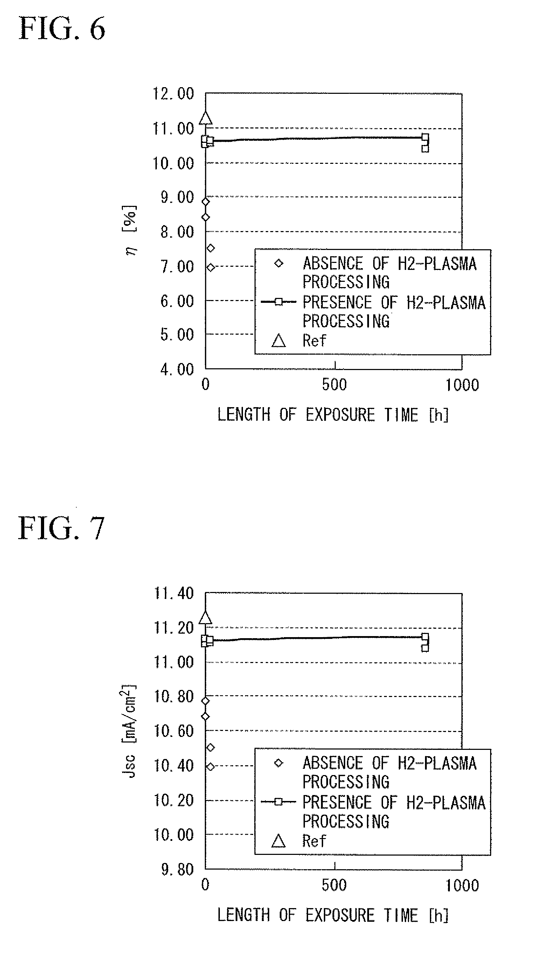

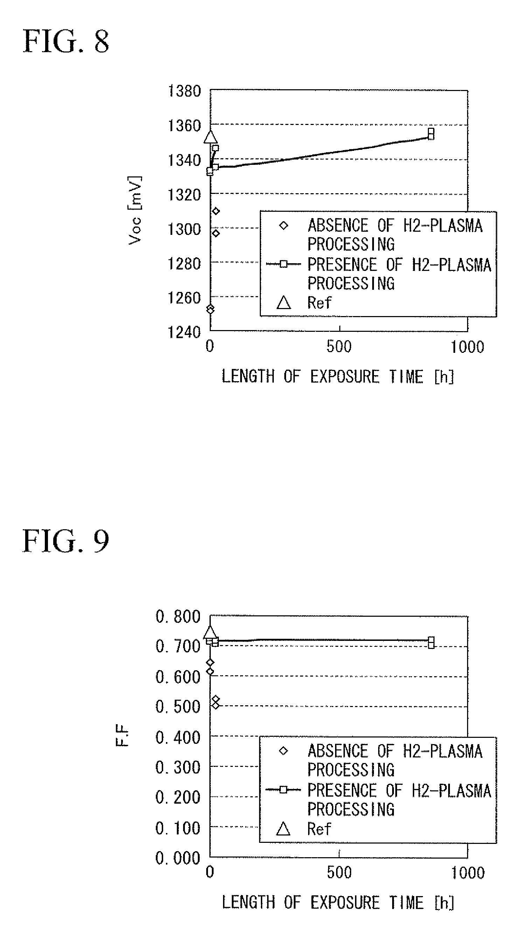

In addition, FIGS. 6 to 9 respectively show the relationships between the length of time during the p-layer being exposed to an air atmosphere, and the photoelectric conversion efficiency, the Jsc, the Voc, and the FF.

**Table 2**

| EXPERIMENTAL EXAMPLE | LENGTH OF EXPOSURE TIME | H-PLASMA PROCESSING | CONVERSION EFFICIENCY *η* [%] | Jsc [mA/cm²] | Voc [mV] | F. F. | Ic/Ia |
|---|---|---|---|---|---|---|---|
| 1 | 5 MINUTES | ABSENCE | 8.42 | 10.97 | 1252 | 0.613 | 2.041 |
| 2 | 5 MINUTES | PRESENCE | 10.64 | 11.04 | 1333 | 0.722 | 2.807 |
| 3 | 22 HOURS | ABSENCE | 7.52 | 11.01 | 1310 | 0.521 | 2.191 |
| 4 | 22 HOURS | PRESENCE | 10.60 | 11.09 | 1335 | 0.716 | 2.374 |
| 5 | 860 HOURS | PRESENCE | 10.72 | 11.03 | 1353 | 0.719 | 2.601 |
| 6 | 0 HOURS (NONE) | ABSENCE | 11.30 | 11.23 | 1353 | 0.744 | 2.969 |

As evidenced by Table 2, and FIGS. 6 to 9, when comparing experimental examples 1 and 3 in which the p-layer of the second-photoelectric conversion unit was exposed to an air atmosphere, and experimental example 6 in which the p-layer was not exposed to an air atmosphere, it was confirmed that the characteristics are degraded by exposing p-layer to an air atmosphere, and it was also found that the degree of degradation of the characteristics becomes greater with increased length of exposure time.

On the other hand, when comparing experimental example 1 and experimental example 2 and comparing experimental example 3 and experimental example 4, the above degradation was suppressed in experimental examples 2 and 4 in which the hydrogen radical plasma processing was performed, and it was found that good characteristics were obtained which were substantially equal to experimental example 6 in which the p-layer was not exposed to an air atmosphere.

Specifically, even the case where the p-layer was exposed for 860 hours such as example 5, due to performing the hydrogen radical plasma processing, good characteristics were obtained which were substantially equal to experimental example 6 in which the p-layer was not exposed to an air atmosphere.

As evidenced by FIG. 5 showing the relationship between an electrical-current density and a voltage, due to performing the hydrogen radical plasma processing, good curve was obtained which is similar to quadrangular shape.

As described above, due to performing the hydrogen radical plasma processing on the p-layer of the second-photoelectric conversion unit, it was found that a photoelectric conversion device having excellent photoelectric conversion characteristics can be manufactured even if the p-layer is exposed to an air atmosphere for a long period of time.
(2) In the experimental example described below, the relationship between the length of plasma processing time and the photoelectric conversion characteristics was evaluated.

### Experimental Example 7

In experimental example 7, a p-layer and an i-layer which are composed of an amorphous silicon (a-Si) based thin film were formed on the substrate as a first-photoelectric conversion unit, an n-layer including microcrystalline silicon (µc-Si) was formed on the i-layer, and a p-layer that includes microcrystalline silicon (µc-Si) and constitutes a second-photoelectric conversion unit was formed.

The layers described above were continuously formed in a vacuum atmosphere, and reaction chambers in which the layers are formed were different from each other.

Thereafter, the p-layer of the second-photoelectric conversion unit was exposed to an air atmosphere, and the p-layer of the second-photoelectric conversion unit was subjected to a plasma processing including a hydrogen radical.

Subsequently, an i-layer and an n-layer, which constitute the second-photoelectric conversion unit and are composed of microcrystalline silicon (µc-Si), were formed.

In experimental example 7, the p-layer, the i-layer, and the n-layer of the first-photoelectric conversion unit, and the p-layer of second-photoelectric conversion unit were formed by a plasma CVD method.

The reaction chambers in which the p-layer, the i-layer, and the n-layer of the first-photoelectric conversion unit, and the p-layer of the second-photoelectric conversion unit are formed were different from each other.

On the other hand, the i-layer and the n-layer of the second-photoelectric conversion unit were formed in the same reaction chamber using a plasma CVD method.

The p-layer of the first-photoelectric conversion unit having a film thickness of 80Å was formed, under conditions in which the substrate temperature was 170°C, the power source output was 40W, the internal pressure of the reaction chamber was 80 Pa, the E/S was 20mm, and the flow rates of the reactive gases were 150 sccm of monosilane (SiH₄), 470 sccm of hydrogen (H₂), 45 sccm of diborane (B₂H₆/H₂) using hydrogen as a diluted gas, and 300 sccm of methane (CH₄).

Additionally, a buffer layer having a film thickness of 60Å was formed, under conditions in which the substrate temperature was 170°C, the power source output was 40W, the internal pressure of the reaction chamber was 60 Pa, the E/S was 17mm, and the flow rates of the reactive gases were 150 sccm of monosilane (SiH₄), 1500 sccm of hydrogen (H₂), and 0 sccm to 200 sccm of methane (CH₄).

In addition, the i-layer of the first-photoelectric conversion unit having a film thickness of 1800Å was formed, under conditions in which the substrate temperature was 170°C, the power source output was 40W, the internal pressure of the reaction chamber was 40 Pa, the E/S was 14mm, and the flow rate of the reactive gas was 300 sccm of monosilane (SiH₄).

Furthermore, the n-layer of the first-photoelectric conversion unit having a film thickness of 100Å was formed, under conditions in which the substrate temperature was 170°C, the power source output was 1000W, the internal pressure of the reaction chamber was 800 Pa, the E/S was 14mm, and the flow rates of the reactive gases were 20 sccm of monosilane (SiH₄), 2000 sccm of hydrogen (H₂), and 15 sccm of phosphine (PH₃/H₂) using hydrogen as a diluted gas.

Next, the p-layer of the second-photoelectric conversion unit having a film thickness of 150Å was formed, under conditions in which the substrate temperature was 170°C, the power source output was 750W, the internal pressure of the reaction chamber was 1200 Pa, the E/S was 9mm, and the flow rates of the reactive gases were 30 sccm of monosilane (SiH₄), 9000 sccm of hydrogen (H₂), and 12 sccm of diborane (B₂H₆/H₂) using hydrogen as a diluted gas.

Here, the p-layer of the second-photoelectric conversion unit was exposed to an air atmosphere for twenty-four hours.

The p-layer was subjected to the hydrogen radical plasma processing for thirty seconds under conditions in which the substrate temperature was 170°C, the power source output was 500W, the internal pressure of the reaction chamber was 400 Pa, and H₂ which serves as a processing gas was 1000 sccm.

Continuously, the i-layer of the second-photoelectric conversion unit having a film thickness of 15000Å was formed, under conditions in which the substrate temperature was 170°C, the power source output was 550W, the internal pressure of the reaction chamber was 1200 Pa, the E/S was 9mm, and the flow rates of the reactive gases were 45 sccm of monosilane (SiH₄) and 3150 sccm of hydrogen (H₂).

Furthermore, the n-layer of the second-photoelectric conversion unit having a film thickness of 300Å was formed, under conditions in which the substrate temperature was 170°C, the power source output was 1000W, the internal pressure of the reaction chamber was 800 Pa, the E/S was 14mm, and the flow rates of the reactive gases were 20 sccm of monosilane (SiH₄), 2000 sccm of hydrogen (H₂), and 15 sccm of phosphine (PH₃/H₂) using hydrogen as a diluted gas.

### Experimental Example 8

In this experimental example, in a manner similar to experimental example 6, after the p-layer, the i-layer, and the n-layer of the first-photoelectric conversion unit, and the p-layer of the second-photoelectric conversion unit were formed on the substrate, the p-layer of the second-photoelectric conversion unit was exposed to an air atmosphere for twenty-two hours.

The p-layer was subjected to the hydrogen radical plasma processing for sixty seconds under conditions in which the substrate temperature was 170°C, the power source output was 500W, the internal pressure of the reaction chamber was 400 Pa, and H₂ which serves as a processing gas was 1000 sccm.

Thereafter, in a manner similar to experimental example 7, the i-layer and the n-layer of the second-photoelectric conversion unit were formed.

### Experimental Example 9

In this experimental example, in a manner similar to experimental example 6, after the p-layer, the i-layer, and the n-layer of the first-photoelectric conversion unit, and the p-layer of the second-photoelectric conversion unit were formed on the substrate, the p-layer of the second-photoelectric conversion unit was exposed to an air atmosphere for twenty-four hours.

The p-layer was subjected to the hydrogen radical plasma processing for 120 seconds under conditions in which the substrate temperature was 170°C, the power source output was 500W, the internal pressure of the reaction chamber was 400 Pa, and H₂ which serves as a processing gas was 1000 sccm.

Subsequently, in a manner similar to experimental example 6, the i-layer and the n-layer of the second-photoelectric conversion unit were formed.

### Experimental Example 10

In this experimental example, in a manner similar to experimental example 6, after the p-layer, the i-layer, and the n-layer of the first-photoelectric conversion unit, and the p-layer of the second-photoelectric conversion unit were formed on the substrate, the p-layer of the second-photoelectric conversion unit was exposed to an air atmosphere for twenty-four hours.

The p-layer was subjected to the hydrogen radical plasma processing for 300 seconds under conditions in which the substrate temperature was 170°C, the power source output was 500W, the internal pressure of the reaction chamber was 400 Pa, and H₂ which serves as a processing gas was 1000 sccm.

Thereafter, in a manner similar to experimental example 7, the i-layer and the n-layer of the second-photoelectric conversion unit were formed.

### Experimental Example 11

In this experimental example, in a manner similar to experimental example 7, the p-layer, the i-layer, and the n-layer of the first-photoelectric conversion unit, and the p-layer of the second-photoelectric conversion unit were formed on the substrate.

In this experimental example 11, the processing for exposing the p-layer to an air atmosphere and the hydrogen radical plasma processing were not performed, thereafter, the i-layer and the n-layer of the second-photoelectric conversion unit were formed in a manner similar to experimental example 7.

The respective film formation conditions for forming layers of the photoelectric conversion devices that were manufactured in experimental examples 7 to 11, were shown in Table 3.

**Table 3**

| PHOTOELECTRIC CONVERSION UNIT | | TEMPERATURE [°C] | OUTPUT [W] | PRESSURE [Pa] | E/S [mm] | FLOW RATES[sccm] | | | | | THICKNESS [A] |
|---|---|---|---|---|---|---|---|---|---|---|---|
| | | | | | | SiH₄ | H₂ | B₂H₆/H₂ | CH₄ | PH₃/H₂ | |
| FIRST | p-LAYER | 170 | 40 | 80 | 20 | 150 | 470 | 45 | 300 | - | 80 |
| | Buffer | 170 | 40 | 60 | 17 | 150 | 1500 | - | 200>0 | - | 60 |
| | i-LAYER | 170 | 40 | 40 | 14 | 300 | - | - | - | - | 1800 |
| | n-LAYER | 170 | 1000 | 800 | 14 | 20 | 2000 | - | - | 15 | 100 |
| SECOND | p-LAYER | 170 | 750 | 1200 | 9 | 30 | 9000 | 12 | - | - | 150 |
| | i-LAYER | 170 | 550 | 1200 | 9 | 45 | 3150 | - | - | - | 15000 |
| | n-LAYER | 170 | 1000 | 800 | 14 | 20 | 2000 | - | - | 15 | 300 |

The output characteristics of the photoelectric conversion devices of experimental examples 7 to 11 which have been manufactured in the above-described manner were measured at a temperature of 25°C by irradiating with light of AM 1.5 with a light quantity of 100 mW/cm²; and a photoelectric conversion efficiency (η), a short-circuited current (Jsc), an open voltage (Voc), a fill factor (FF), and Ic/Ia were evaluated.

The results were shown in Table 4.

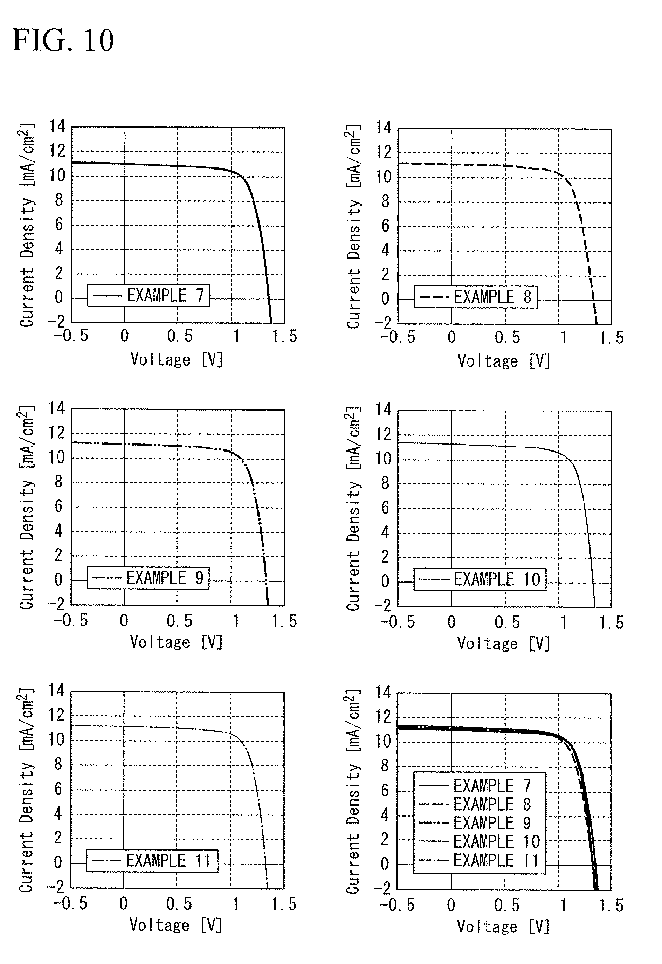

Additionally, in the photoelectric conversion devices of experimental examples 7 to 11, the relationship between an electrical-current density and a voltage is shown in FIG. 10.

FIG. 10 shows characteristic curves indicating experimental examples, respectively, and characteristic curves collectively indicating experimental examples 7 to 11.

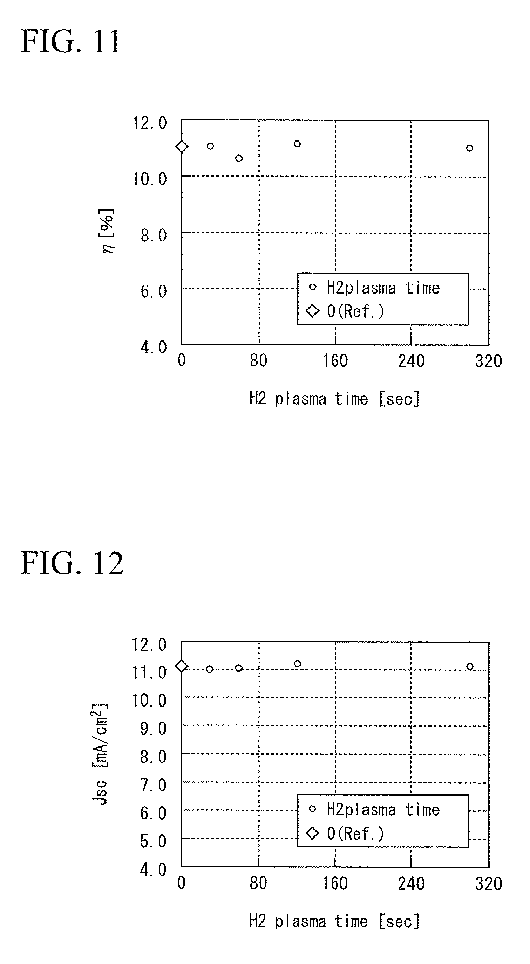

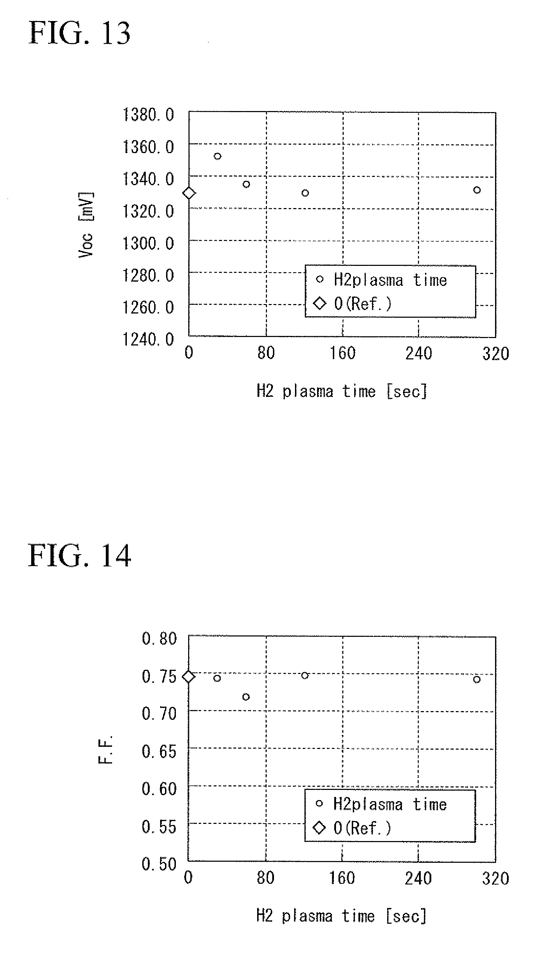

In addition, FIGS. 11 to 14 respectively show the relationships between the length of hydrogen radical plasma processing time, and the photoelectric conversion efficiency, the Jsc, the Voc, and the FF.

**Table 4**

| EXPERIMENTAL EXAMPLE | H-PLASMA PROCESSING | LENGTH OF EXPOSURE TIME | CONVERSION EFFICIENCY *η* [%] | Jsc [mA/cm²] | Voc [mV] | F. F. |
|---|---|---|---|---|---|---|
| 7 | 30 SECONDS | 24 HOURS | 11.04 | 11.03 | 1353 | 0.740 |
| 8 | 60 SECONDS | 22 HOURS | 10.60 | 11.09 | 1335 | 0.716 |
| 9 | 120 SECONDS | 24 HOURS | 11.13 | 11.25 | 1330 | 0.744 |
| 10 | 300 SECONDS | 24 HOURS | 11.01 | 11.15 | 1332 | 0.741 |
| 11 | 0 (NONE) | 0 (NONE) | 11.04 | 11.13 | 1329 | 0.743 |

As evidenced by Table 4, and FIGS. 10 to 14, even the p-layer of the second-photoelectric conversion unit was exposed to an air atmosphere, it was found that, due to performing the hydrogen radical plasma processing, good photoelectric conversion characteristics were obtained without degradation of the characteristics, particularly, a similar effect is obtained without relying on the length of hydrogen radical plasma processing time.

As described above, it was found that, the p-layer of the second-photoelectric conversion unit is continuously formed in addition to the p-layer, the i-layer, and the n-layer of the first-photoelectric conversion unit, subsequently, the p-layer of the second-photoelectric conversion unit is exposed to an air atmosphere, thereafter, the i-layer and the n-layer of the second-photoelectric conversion unit is formed, as a result, it is possible to manufacture a photoelectric conversion device having a high level of photoelectric conversion characteristics.

Additionally, it was found that, due to performing the hydrogen radical plasma processing on the p-layer of the second-photoelectric conversion unit, it is possible to manufacture a photoelectric conversion device having further excellent photoelectric conversion characteristics, as compared with the case where the p-layer was exposed to an air atmosphere.

As described above, in the photoelectric conversion device manufacturing method of the present invention, it is preferable that a p-type semiconductor layer of the second-photoelectric conversion unit (second p-type semiconductor layer) which was exposed to an air atmosphere be exposed to plasma including a hydrogen radical before an i-type semiconductor layer (second i-type semiconductor layer) constituting a second-photoelectric conversion unit is formed.

Moreover, it is preferable that a p-type semiconductor layer (third p-type semiconductor layer) be formed after an n-type semiconductor layer (second n-type semiconductor layer) of the second-photoelectric conversion unit is formed.

Because of this, the reaction chamber becomes an atmosphere including a gas (B₂H₆ (p-type dopant) atmosphere) which is used for forming the p-type semiconductor at the time of transferring the substrate from the reaction chamber, therefore, remaining of PH₃ (n-type dopant) in the reaction chamber is suppressed at the time of transferring a next substrate to the reaction chamber.

Consequently, when an i-type semiconductor layer (second i-type semiconductor layer) is formed on the next substrate, PH₃ (n-type dopant) which is doped into the side of the i-type semiconductor layer which is adjacent to the p-type semiconductor layer is suppressed, and it is thereby possible to suppress degradation of the characteristics.

Furthermore, in order to form an i-type semiconductor layer having a purity, it is preferable that cyclic purging is sufficiently performed in the reaction chamber with hydrogen before transferring the next substrate thereto or before forming the i-type semiconductor layer of the second-photoelectric conversion unit on the next substrate.

Additionally, before forming an i-type semiconductor layer, a hydrogen plasma processing is performed in a state where the reaction chamber is in an atmosphere including a gas (atmosphere including B₂H₆ gas (p-type dopant)) which is used for forming a p-type semiconductor, thereafter, an i-type semiconductor layer and an n-type semiconductor layer may be formed.

It is possible to control a p-type atmosphere, p-i junction is easily controlled, and it is thereby possible to form a photoelectric conversion device having further good performance.

### Industrial Applicability

As described above in detail, the present invention is applicable to a method for manufacturing a photoelectric conversion device having an excellent power generation capability, a photoelectric conversion device, and a photoelectric conversion device manufacturing system, in which unsharpness of junction due to impurities in the p-layer constituting a second-photoelectric conversion unit being diffused in an i-layer or due to remaining impurities being doped into a p-layer and an n-layer is not generated in the photoelectric conversion device.

## Claims

1. A photoelectric conversion device manufacturing method, comprising:
continuously forming a first p-type semiconductor layer, a first i-type semiconductor layer, and a first n-type semiconductor layer, which constitute a first-photoelectric conversion unit, and a second p-type semiconductor layer which constitutes a second-photoelectric conversion unit, in decompression chambers that are different from each other;
exposing the second p-type semiconductor layer to an air atmosphere; and
forming a second i-type semiconductor layer and a second n-type semiconductor layer, which constitute the second-photoelectric conversion unit, on the second p-type semiconductor layer that was exposed to the air atmosphere, in the same decompression chamber.

2. The photoelectric conversion device manufacturing method according to claim 1, further comprising:
exposing the second p-type semiconductor layer that was exposed to the air atmosphere to plasma including a hydrogen radical before forming the second i-type semiconductor layer.

3. The photoelectric conversion device manufacturing method according to claim 2, wherein
when exposing the second p-type semiconductor layer to plasma including the hydrogen radical, a hydrogen gas is used.

4. The photoelectric conversion device manufacturing method according to claim 2, wherein
the second p-type semiconductor layer is exposed to plasma including a hydrogen radical in an atmosphere having a dopant gas to be introduced into the second p-type semiconductor layer, before forming the second i-type semiconductor layer.

5. The photoelectric conversion device manufacturing method according to any one of claims 1 to 4, wherein
a crystalline-silicon-based thin film is formed as the first n-type semiconductor layer.

6. The photoelectric conversion device manufacturing method according to any one of claims 1 to 5, further comprising:
forming a third p-type semiconductor layer after forming the second i-type semiconductor layer and the second n-type semiconductor layer.

7. A photoelectric conversion device formed by the photoelectric conversion device manufacturing method according to any one of claims 1 to 6.

8. A photoelectric conversion device manufacturing system, comprising:
a first-film-formation apparatus that forms a first p-type semiconductor layer, a first i-type semiconductor layer, and a first n-type semiconductor layer, which constitute a first-photoelectric conversion unit, and a second p-type semiconductor layer which constitutes a second-photoelectric conversion unit, and that includes a plurality of plasma-CVD reaction chambers which are connected so as to maintain a reduced-pressure atmosphere;
a discharge apparatus that transfers the substrate on which the second p-type semiconductor layer is formed, to an air atmosphere; and
a second-film-formation apparatus that stores the substrate which was transferred to the air atmosphere, and that includes a plasma-CVD reaction chamber in which a second i-type semiconductor layer and a second n-type semiconductor layer, which constitute the second-photoelectric conversion unit, are formed in a reduced-pressure atmosphere.

9. The photoelectric conversion device manufacturing system according to claim 8, wherein
the second-film-formation apparatus exposes the second p-type semiconductor layer that was exposed to the air atmosphere, to plasma including a hydrogen radical before forming the second i-type semiconductor layer.

10. The photoelectric conversion device manufacturing system according to claim 8, wherein
the second-film-formation apparatus has a gas-introduction section introducing a hydrogen gas thereinto; and the second p-type semiconductor layer is subjected to plasma including the hydrogen radical by use of the hydrogen gas that is introduced by the gas-introduction section.

11. The photoelectric conversion device manufacturing system according to claim 9, wherein
the second p-type semiconductor layer is subjected to plasma including the hydrogen radical in the plasma-CVD reaction chamber in which the second i-type semiconductor layer and the second n-type semiconductor layer are formed.

12. The photoelectric conversion device manufacturing system according to claim 9, wherein
the second p-type semiconductor layer is subjected to plasma including a hydrogen radical in an atmosphere having a dopant gas to be introduced into the second p-type semiconductor layer, before forming the second i-type semiconductor layer.

13. The photoelectric conversion device manufacturing system according to any one of claims 8 to 12, wherein
the first-film-formation apparatus forms a crystalline-silicon-based thin film as the first n-type semiconductor layer.

14. The photoelectric conversion device manufacturing system according to any one of claims 8 to 13, wherein
a third p-type semiconductor layer is formed after forming the second i-type semiconductor layer and the second n-type semiconductor layer.
